# EUROPEAN PATENT APPLICATION

(11) **EP 4 608 105 A1**
(43) Date of publication of application: **27.08.2025**
(21) Application number: 23879716.1
(22) Date of filing: 13.10.2023
(51) Int. Cl.: H10K 30/50, H10K 30/40, H10K 30/86, H10K 85/60

(54) **PHOTOELECTRIC CONVERSION ELEMENT**

(30) Priority: 19.10.2022 JP 2022167637; 22.09.2023 JP 2023158475
(71) Applicant: CANON KABUSHIKI KAISHA, Tokyo 146-8501 (JP)
(72) Inventor: OHSAWA, Tatsuya, Tokyo 146-8501 (JP); MARUYAMA, Akihiro, Tokyo 146-8501 (JP); IWASAKI, Shuhei, Tokyo 146-8501 (JP); NISHIDA, Tsutomu, Tokyo 146-8501 (JP)
(74) Representative: TBK
(86) International application number: PCT/JP2023/037138
(87) International publication number: WO 2024/085073

(57) **Abstract**

To provide a photoelectric conversion element, which has high initial conversion efficiency and in which the conversion efficiency less deteriorates (reduces) when the photoelectric conversion element is continuously used over a long time period, provided is the following photoelectric conversion element: a photoelectric conversion element including: a first electrode; a second electrode; and a photoelectric conversion layer containing a crystal having a perovskite structure arranged between the first electrode and the second electrode, wherein the photoelectric conversion element includes, between the photoelectric conversion layer and the first electrode, a charge-transporting layer containing a phthalocyanine compound and an aromatic ring compound having a hydroxy group different from the phthalocyanine compound.

## Description

### [Technical Field]

The present invention relates to a photoelectric conversion element.

### [Background Art]

In order to solve a problem of depletion of fossil energy and a global environmental problem caused by the use of fossil energy, investigations on a renewable and clean alternative energy source, such as solar energy, wind power, or water power, have been actively performed. Among those, an interest in a solar cell that directly changes sunlight into electrical energy has largely increased. The term "solar cell" as used herein means a battery that generates a current-voltage utilizing a photovoltaic effect in which light energy is absorbed from sunlight to generate an electron and a hole.

Currently, an n-p diode-type silicon (Si) single crystal-based solar cell having a light energy conversion efficiency of more than 20% has been widely known, and has been actually used in solar power generation. However, the solar cell requires a high temperature treatment step, and the price of a material itself is high, and hence it is a problem that the cost per unit electric power is high. In addition, the problem is one of the supply property in terms of a silicon resource.

Meanwhile, a solar cell using an organic material (hereinafter also referred to as "organic solar cell") does not require the high temperature treatment step, and is a sheet-shaped substrate in which production in a so-called roll to roll system is enabled, and hence cost reduction is enabled. Further improvements in power generation efficiency and durability have been desired for practical use of the organic solar cell. In particular, as a photoelectric conversion layer, progress has been made in development of a crystal having a perovskite structure (including a perovskite crystal) as a material for the practical use of the solar cell because the crystal is excellent in photoelectric conversion property. For example, Patent Literature 1 is a description that an open end voltage is increased by incorporating fullerene C60 into an intermediate layer on a perovskite layer. Patent Literature 2 is a description that durability is improved when an intermediate layer containing thiocyanic acid is present on a perovskite layer. Patent Literature 3 is a description that photoelectric conversion efficiency is improved when an intermediate layer containing 2-phenylethylammonium bromide is present on a perovskite layer.

### [Citation List]

### [Patent Literature]

PTL 1: Japanese Patent Application Laid-Open No. 2020-13982
PTL 2: Japanese Patent Application Laid-Open No. 2019-71500
PTL 3: Japanese Patent Application Laid-Open No. 2022-27575

### [Summary of Invention]

### [Technical Problem]

According to investigations made the inventors of the present invention, in each of the photoelectric conversion elements described in Patent Literatures 1 to 3, a surface change of a crystal having a perovskite structure when energization cannot be suppressed, and it has been a problem in that conversion efficiency deteriorates (reduces) when the photoelectric conversion element is continuously used over a long time period.

Accordingly, an object of the present invention is to provide a photoelectric conversion element, which has high initial conversion efficiency and in which the conversion efficiency less deteriorates (reduces) when the photoelectric conversion element is continuously used over a long time period.

### [Solution to Problem]

A first aspect of the present invention is to provide a photoelectric conversion element including: a first electrode; a second electrode; and a photoelectric conversion layer containing a crystal having a perovskite structure arranged between the first electrode and the second electrode, wherein the photoelectric conversion element includes, between the photoelectric conversion layer and the first electrode, a charge-transporting layer (including a hole-transporting layer and an electron-transporting layer) containing a phthalocyanine compound (including a metal-free phthalocyanine, a metal phthalocyanine, or a phthalocyanine derivative derived from the metal-free or metal phthalocyanine) and an aromatic ring compound having a hydroxy group different from the phthalocyanine compound.

A second aspect of the present invention is to provide a photoelectric conversion element including: a first electrode; a second electrode; and a photoelectric conversion layer containing a crystal having a perovskite structure arranged between the first electrode and the second electrode, wherein the photoelectric conversion element includes, between the photoelectric conversion layer and the first electrode, a charge-transporting layer containing a hole-transportable compound and an aromatic ring compound represented by the following general formula [1]: 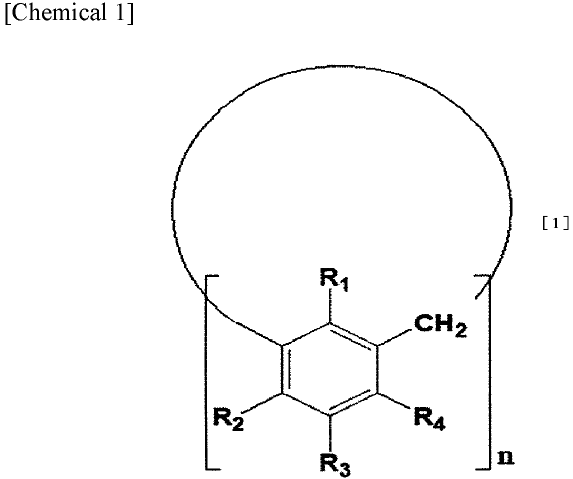 in the general formula [1], R₁ to R₄ represent hydrogen, a halogen atom, a hydroxy group, a substituted or unsubstituted aromatic hydrocarbon group, or a substituted or unsubstituted organic group each independently in each repeating unit and each independently for "n" repeating units, "n" represents an integer of from 3 to 20, and the compound has at least one hydroxy group in a molecule thereof.

### [Advantageous Effects of Invention]

According to the present invention, the photoelectric conversion element in which the reduction of conversion efficiency is suppressed even when the photoelectric conversion element is continuously used for a long time period can be provided.

### [Brief Description of Drawings]

[FIG. 1]

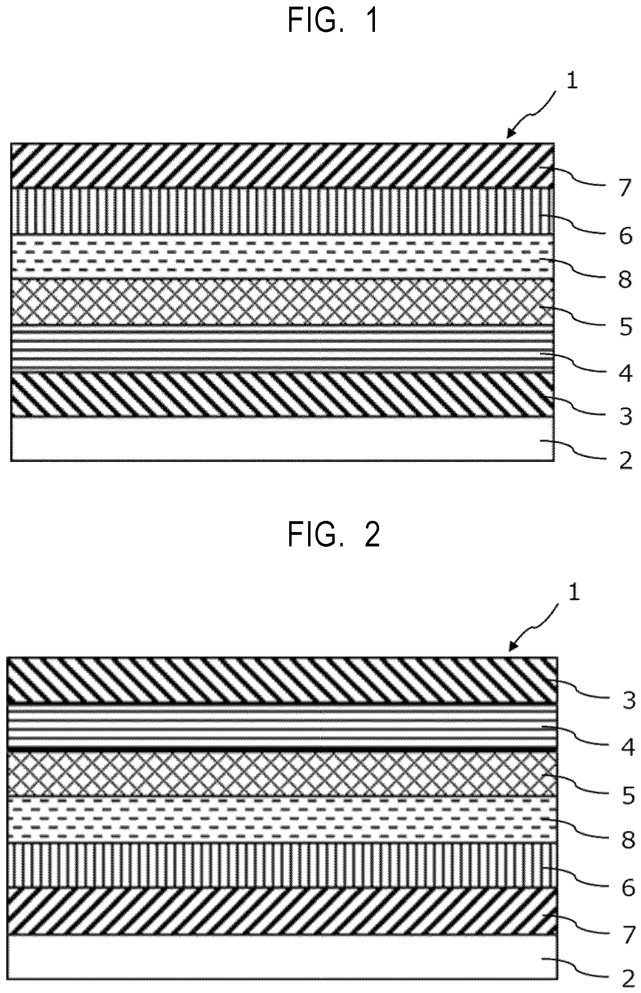

   FIG. 1 is a schematic sectional view in a thickness direction of a photoelectric conversion element according to a first embodiment of the present invention.
[FIG. 2]
   FIG. 2 is a schematic sectional view in a thickness direction of a photoelectric conversion element according to a second embodiment of the present invention.
[FIG. 3]

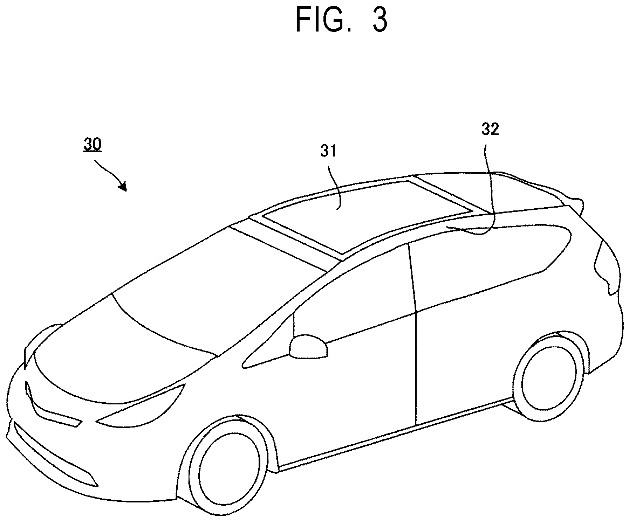

   FIG. 3 is a perspective view for schematically illustrating an example of an application example as a moving body including the photoelectric conversion element of the present invention.
[FIG. 4]

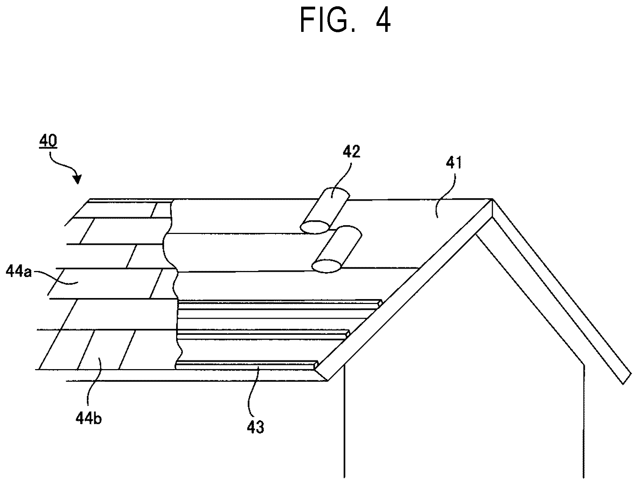

   FIG. 4 is a perspective view for schematically illustrating another example of an application example as a building material including the photoelectric conversion element of the present invention.

### [Description of Embodiments]

### <First Embodiment and Second Embodiment>

A photoelectric conversion element of the present invention is a photoelectric conversion element including: a first electrode; a second electrode; and a photoelectric conversion layer containing a crystal having a perovskite structure arranged between the first electrode and the second electrode, and includes a charge-transporting layer between the photoelectric conversion layer and the first electrode. In addition, the charge-transporting layer according to the present invention has any one of the following features (1) and (2).
(1) The charge-transporting layer contains a phthalocyanine compound and an aromatic ring compound having a hydroxy group different from the phthalocyanine compound. In the present invention, the phthalocyanine compound includes phthalocyanine and a phthalocyanine derivative (compound derived from phthalocyanine).
(2) The charge-transporting layer contains a hole-transportable compound and an aromatic ring compound having a calixarene structure.

First, the above-mentioned feature (1) is described.

As a result of investigations made by the inventors of the present invention, the inventors have found that, when the photoelectric conversion element includes the charge-transporting layer of the above-mentioned feature (1), a photoelectric conversion element excellent in surface stability of the crystal having a perovskite structure is obtained. The details of the reason why high stability is obtained in the present invention are not clear, but are conceived to be as described below.

When the phthalocyanine compound as a particle is formed into a film, high crystallinity is maintained, the original charge-transporting ability of phthalocyanine can be exhibited. Further, in the investigations that have heretofore been made by the inventors of the present invention, it is assumed that unevenness in a submicron scale occurs on a surface when the photoelectric conversion layer contains a perovskite compound, and hence interfacial joining is improved by filling a recess of such unevenness with a phthalocyanine compound particle, and high photoelectric conversion efficiency can be obtained. However, it has been found that, in lamination of the phthalocyanine compound particle, a change in a surface of the crystal having a perovskite structure when energization cannot be suppressed. In the present invention, the suppression of the deterioration of the crystal having a perovskite structure is enabled by incorporating the aromatic ring compound having a hydroxy group different from the phthalocyanine compound into the charge-transporting layer containing the phthalocyanine compound particle. It is presumed that the aromatic ring compound having a hydroxy group enters between the phthalocyanine compound particle and the crystal having a perovskite structure. The crystal having a perovskite structure is a hydrogen-bonding crystal, and hence it is conceived that the aromatic ring compound having a hydroxy group causes a hydrogen-bonding interaction with the surface of the crystal having a perovskite structure. It is conceived that, through the interaction with the surface of the crystal having a perovskite structure, when the crystal having a perovskite structure changes into a stable state in energizating, the surface of the crystal is chemically fixed by the above-mentioned interaction, and hence the change in the surface of the crystal is suppressed.

The inventors of the present invention conceive that, when the aromatic ring compound having a hydroxy group is combined with the phthalocyanine compound, an interaction with the surface of the crystal having a perovskite structure is enabled. It is presumed that fused rings of the phthalocyanine compound strongly interact with each other, and hence an aromatic ring of the aromatic ring compound having a hydroxy group interacts with the surface of the phthalocyanine compound. As a result, it is conceived that an interaction of a hydroxy group of the aromatic ring of the aromatic ring compound having a hydroxy group in a direction of a crystal having a perovskite structure is increased. It is preferred that, when the content of the phthalocyanine compound in the charge-transporting layer is set to 100 parts by mass, the aromatic ring compound having a hydroxy group in the charge-transporting layer be added in the range of the content (part(s) by mass) of 0.5 part by mass or more and 50 parts by mass or less from a viewpoint of strength of an interaction with a surface of the crystal having a perovskite structure. In addition, the molecular weight of the aromatic ring compound having a hydroxy group is preferably 10,000 or less from a viewpoint of a molecular size, in order to facilitate the interaction with the surface of the crystal having a perovskite structure.

In addition, it has been found that, when a number of hydroxy groups in the aromatic ring compound is larger than a number of hydroxy groups in the phthalocyanine compound, the aromatic ring compound and a surface of the crystal having a perovskite structure easily interact with each other, and hence a change in the surface of the crystal is easily suppressed. In the present invention, the number of hydroxy groups in the aromatic ring compound is preferably larger than the number of hydroxy groups in the phthalocyanine compound. In particular, the number of hydroxy groups in the aromatic ring compound having a hydroxy group is more preferably 3 or more, particularly preferably 4 or more from a viewpoint of the strength of a hydrogen bond. The aromatic ring compound having a hydroxy group more preferably has a cyclic structure because density of the hydrogen bond between the compound and the surface of the crystal having a perovskite structure increases, and the compound preferably has, for example, a calixarene structure, such as calix-4 arene or calix-8 arene. It has been found that a combination obtained by mixing a plurality of calix-4 arenes is particularly excellent.

In the present invention, the charge-transporting layer may contain one kind of aromatic ring compound, but preferably contains a plurality of kinds of aromatic ring compounds. Specifically, the aromatic ring compound having a calixarene structure to be preferably used in the present invention is preferably a compound represented by the following general formula [1].

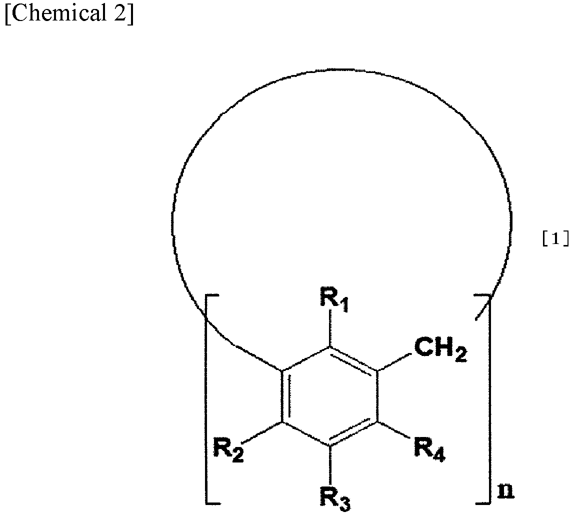

In the general formula [1], R₁ to R₄ represent hydrogen, a halogen atom, a hydroxy group, a substituted or unsubstituted aromatic hydrocarbon group, or a substituted or unsubstituted organic group each independently in each repeating unit and each independently for "n" repeating units, "n" represents an integer of from 3 to 20, and the compound has at least one hydroxy group in a molecule thereof. In addition, the present invention is directed to a photoelectric conversion element including: a first electrode; a second electrode; and a photoelectric conversion layer containing a crystal having a perovskite structure arranged between the first electrode and the second electrode, wherein the photoelectric conversion element includes, between the photoelectric conversion layer and the first electrode, a charge-transporting layer containing a hole-transportable compound and the aromatic ring compound represented by the general formula [1]. In the present invention, the structure of the compound may be determined by analysis based on data measured with, for example, a nuclear magnetic resonance apparatus (NMR).

An example of the organic group is a group represented by the general formula -Y-Ar, where -Y- represents -CH=N-, -CH=CH-, or -N=N-, and Ar represents a substituted or unsubstituted aromatic hydrocarbon group, or a substituted or unsubstituted heterocyclic group.

Examples of the aromatic hydrocarbon represented by each of R₁ to R₄ and the aromatic hydrocarbon represented by Ar include benzene, naphthalene, fluorene, phenanthrene, anthracene, fluoranthene, and pyrene. In addition, examples of the heterocycle represented by Ar include furan, thiophene, pyridine, indole, benzothiazole, carbazole, benzocarbazole, acridone, dibenzothiophene, benzoxazole, benzotriazole, oxathiazole, thiazole, phenazine, cinnoline, and benzocinnoline.

In addition, examples of a substituent that the aromatic hydrocarbon group represented by each of R₁ to R₄ may have and a substituent that Ar may have include: alkyl groups, such as a methyl group, an ethyl group, a propyl group, and a butyl group; alkoxy groups, such as a methoxy group and an ethoxy group; dialkylamino groups, such as a dimethylamino group and a diethylamino group; alkoxycarbonyl groups, such as a methoxycarbonyl group and an ethoxycarbonyl group; halogen atoms, such as a fluorine atom, a chlorine atom, and a bromine atom; a hydroxy group; a nitro group; a cyano group; and a halomethyl group.

In the aromatic ring compound having a calixarene structure represented by the general formula [1], "n" preferably represents 4 or 8. In addition, it is preferred that R₁s represent a halogen atom or a hydroxy group each independently for "n" repeating units, and at least one R₁ represent a hydroxy group. In addition, it is preferred that R₃s represent a nitrophenylazo group or a dinitrophenylazo group each independently for "n" repeating units.

Specific examples of the aromatic ring compound having a calixarene structure to be preferably used in the present invention are given below. In the present invention, the charge-transporting layer preferably contains, as the aromatic ring compound, at least one selected from the group consisting of: a compound represented by the following formula [C-1]; a compound represented by the following formula [C-2]; a compound represented by the following formula [C-3]; and a compound represented by the following formula [C-4], and the charge-transporting layer more preferably contains, as the aromatic ring compound, the compound represented by the following formula [C-1], the compound represented by the following formula [C-2], the compound represented by the following formula [C-3], and the compound represented by the following formula [C-4].

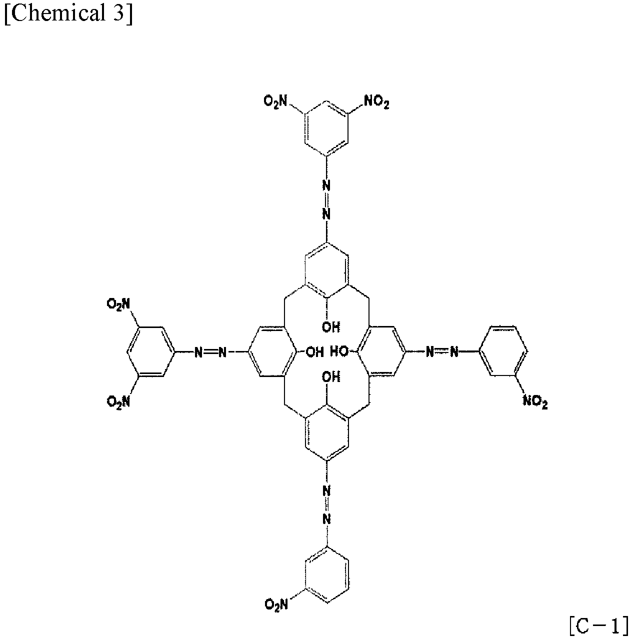

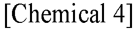

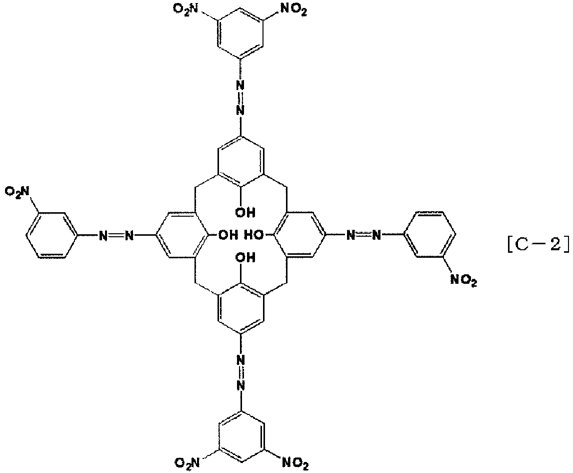

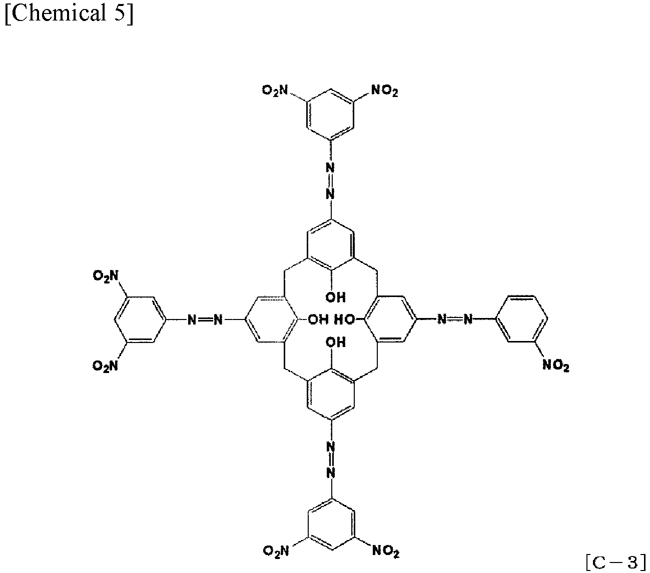

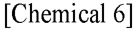

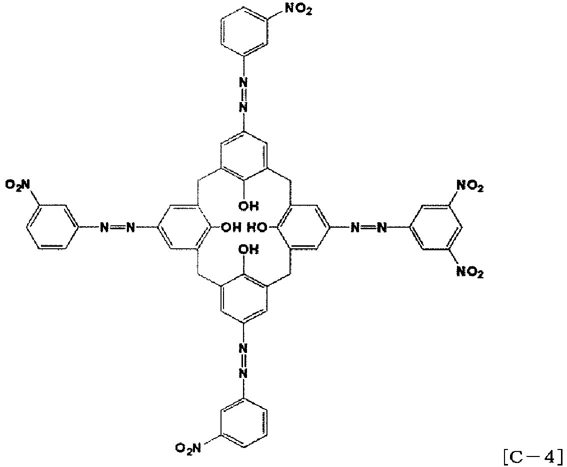

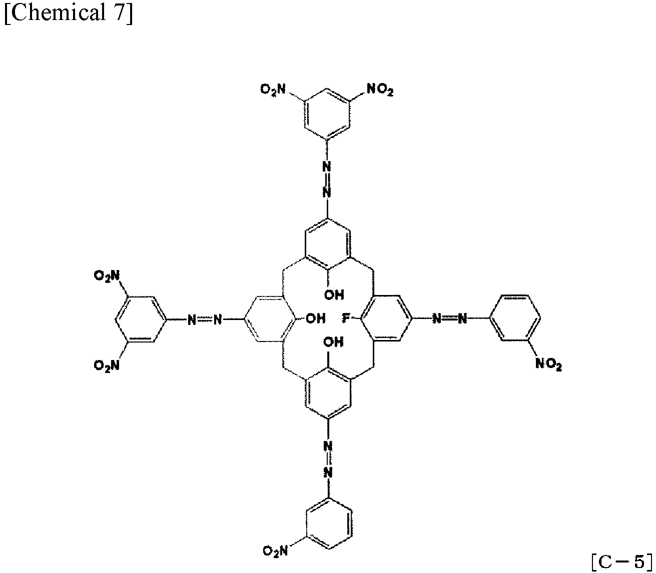

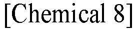

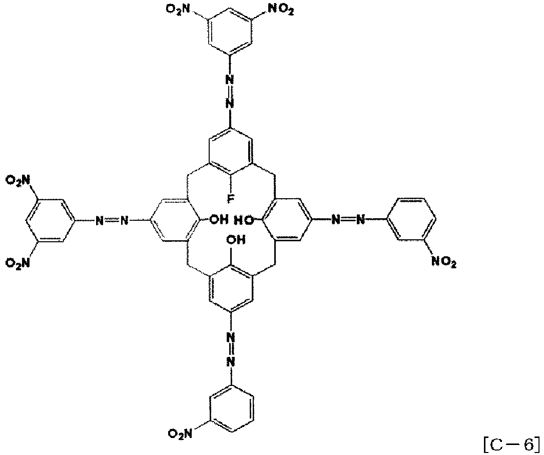

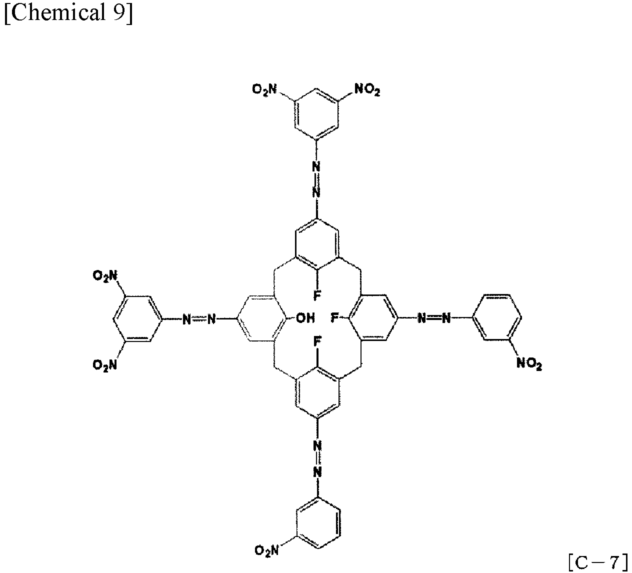

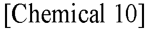

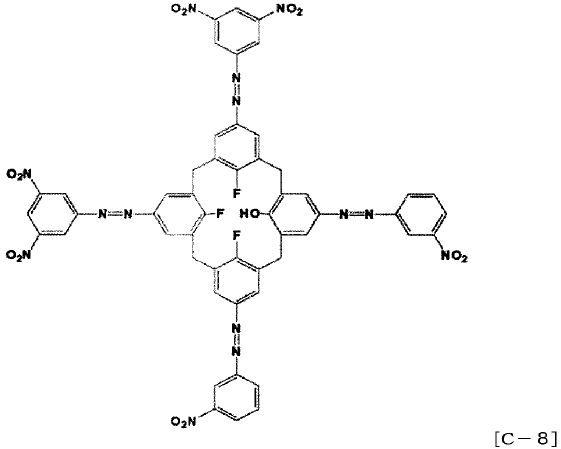

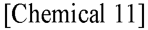

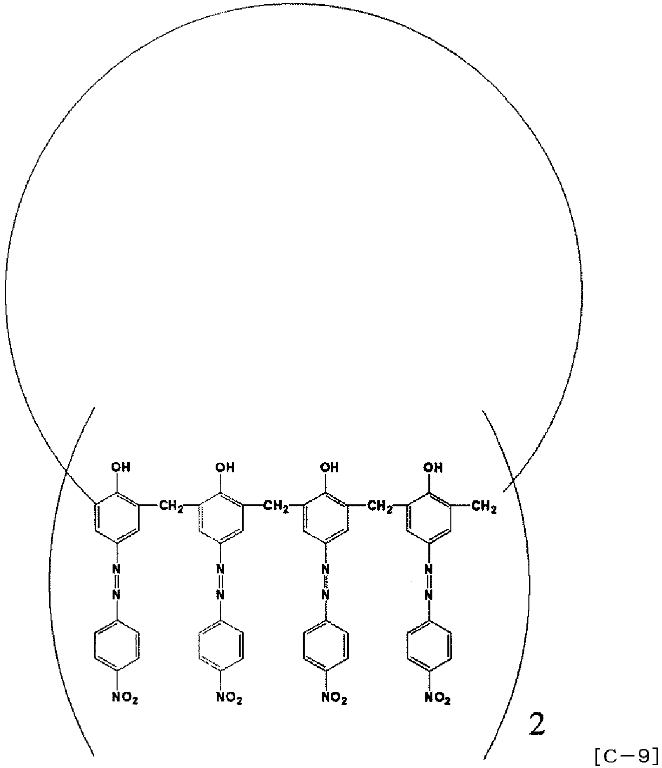

An aromatic ring compound having a non-cyclic structure may be used as the aromatic ring compound having a hydroxy group different from the phthalocyanine compound in addition to the aromatic ring compound having a calixarene structure. Specific examples thereof include phenol, 1-naphthol, benzyl alcohol, cresol, benzenetriol, carboxylic acid, hydroquinone, benzoic acid, phthalic acid, terephthalic acid, and catecholamine.

In the present invention, the phthalocyanine compound is preferably a metal phthalocyanine compound. The phthalocyanine compound to be used in the present invention may have a metal ligand, and as a coordination metal, for example, Ga, Cu, Ti, and Zn, and, among those, Ga is preferred from a viewpoint of crystallinity. The phthalocyanine compound is more preferably a gallium phthalocyanine compound, particularly preferably a hydroxygallium phthalocyanine compound from a viewpoint of the interaction with the aromatic ring compound having a hydroxy group.

In addition, the inventors of the present invention have found an effect in which the aromatic ring compound interacts with the surface of the crystal having a perovskite structure, and the surface is chemically stabilized by a combination of the hole-transportable compound and the aromatic ring compound having a calixarene structure represented by the general formula [1], in addition to the phthalocyanine compound. That is, the charge-transporting layer is the charge-transporting layer of the above-mentioned feature (2). In particular, calix-4-arene in which "n" in the general formula [1] represents 4 is preferred as the aromatic ring compound having a calixarene structure. In addition, such a compound that in the general formula [1], R₁s represent a halogen atom or a hydroxy group each independently for "n" repeating units, at least one R₁ represents a hydroxy group, and R₃s represent a nitrophenylazo group or a dinitrophenylazo group each independently for "n" repeating units is preferred. In particular, a plurality of kinds of calix-4-arenes are preferably mixed and used from a viewpoint of an affinity of the hole-transportable compound.

The hole-transportable compound to be combined with the aromatic ring compound having a calixarene structure is not particularly limited, but 2,2',7,7'-tetrakis-(N,N-di-4-methoxyphenylamino)-9,9'-spirobifluorene (spiro-OMeTAD) and poly(triarylamine) (PTAA) are preferred.

Through the mechanism as described above, the effect of the present invention can be achieved when the respective configurations synergistically affect each other.

Embodiments of the present invention are described in detail below. The present invention is not limited to the following embodiments, and the following embodiments, which are appropriately changed, modified, and etc. based on the ordinary knowledge of a person skilled in the art without departing from a spirit of the present invention, are also encompassed within a scope of the present invention.

The term "layer" as used herein means not only a layer having a clear boundary or a layer having a flat thin film shape but also a layer having a concentration gradient in which an element to be incorporated gradually changes, or a layer that may form a complicatedly intricate structure together with another layer. In addition, the elemental analysis of the layer may be performed by, for example, subjecting a cross-section of the photoelectric conversion element to TOF-SIMS/FE-TEM/EDS-ray analysis measurement to determine an elemental distribution of a specific element.

FIG. 1 is a schematic sectional view in a thickness direction of a photoelectric conversion element according to a first embodiment of the present invention. The photoelectric conversion element includes: a substrate 2; and a second electrode 3, an electron-transporting layer 4, a photoelectric conversion layer 5, a charge-transporting layer 8, a hole-transporting layer 6, and a first electrode 7 arranged on the substrate 2. The first electrode 7 is an anode, and the second electrode 3 is a cathode, and current can be extracted by connecting the first electrode 7 and the second electrode 3 with an external circuit.

FIG. 2 is a schematic sectional view in a thickness direction of a photoelectric conversion element according to a second embodiment of the present invention.

The photoelectric conversion layer 5 is excited by light that has entered the layer through the substrate 2, the second electrode 3, and the electron-transporting layer 4, or the first electrode 7, the hole-transporting layer 6, and the charge-transporting layer 8 to generate an electron or a hole. That is, the photoelectric conversion layer 5 generates a voltage between the first electrode 7 and the second electrode 3. The electron-transporting layer 4 is a layer arranged between the photoelectric conversion layer 5 and the two electrodes 3 and 7, and may not be formed in some cases. The photoelectric conversion element of the present invention may have a form in which a plurality of the electron-transporting layers 4, the photoelectric conversion layers 5, and the hole-transporting layers 6 are laminated, or an electrode may be arranged as required. The photoelectric conversion element to be laminated may be a photoelectric conversion element including, for example, silicon or CIGS. Such form is sometimes called a tandem structure. The respective members are described below.

### [Substrate]

A photoelectric conversion element 1 of the present invention may include the substrate 2, and examples thereof include a transparent glass substrate, such as soda-lime glass and alkali-free glass, a ceramic substrate, and a transparent plastic substrate. When light is taken in from a first electrode 7 side, an opaque material may be used as the substrate 2, and when light is taken in from a second electrode 3 side, the substrate 2 is formed of a transparent material. In addition, both of the first electrode 7 and the second electrode 3 may be formed of a transparent material.

### [Electrode]

A material for the first electrode 7 or the second electrode 3 is not particularly limited, and a material that has hitherto been known may be used. Examples thereof include: metals, such as gold, silver, titanium, and copper; sodium; a sodium-potassium alloy; lithium; magnesium; aluminum; a magnesium-silver mixture; a magnesium-indium mixture; an aluminum-lithium alloy; an Al/Al₂O₃ mixture; and an Al/LiF mixture. Examples of a transparent electrode material include: conductive transparent materials, such as CuI, indium tin oxide (ITO), SnO₂, aluminum zinc oxide (AZO), indium zinc oxide (IZO), gallium zinc oxide (GZO), fluorine-doped tin oxide (FTO), and antimony-doped tin oxide (ATO); and conductive transparent polymers. Those materials may be used alone or in combination thereof. At least one electrode of the first electrode 7 or the second electrode 3 on a light incident side is a transparent electrode, and the other may be a transparent electrode or may also serve as a reflective layer formed of a light reflective material. When the first electrode 7 is on the light incident side, the second electrode 3 and the substrate 2 may be a transparent electrode and a reflective layer, respectively. The transparent electrode may be a patterned electrode.

### [Photoelectric Conversion Layer]

The photoelectric conversion layer 5 contains the crystal having a perovskite structure. The crystal having a perovskite structure to be used in the present invention is preferably a crystal of a compound represented by the following general formula [2] in which a hydrogen bond is easily formed on its surface.

### R-M-X₃ [2]

In the general formula [2], R represents any one of an organic molecule or an inorganic atom, or both thereof, M represents a metal atom, and X represents a halogen atom or a chalcogen atom.

R in the general formula [2] is preferably represented by, for example, CₚNₘHₙ ("p", "m", and "n" each represent a positive integer) in the case of the organic molecule. Specific examples of the organic molecule include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, imidazole, azole, pyrrole, aziridine, azirine, azetidine, azete, imidazoline, carbazole, aniline, pyridine, methylcarboxyamine, ethylcarboxyamine, propylcarboxyamine, butylcarboxyamine, pentylcarboxyamine, hexylcarboxyamine, formamidinium, an ion of guanidine (e.g., methylammonium (CH₃NH₃)), and phenethylammonium. Among those, methylamine, ethylamine, propylamine, butylamine, pentylamine, hexylamine, aniline, pyridine, propylcarboxyamine, butylcarboxyamine, pentylcarboxyamine, formamidinium, an ion of guanidine, and phenethylammonium are preferred, and methylamine, ethylamine, propylamine, pentylcarboxyamine, formamidinium, and an ion of guanidine are more preferred. In addition, the inorganic atom is not particularly limited, but lithium, cesium, sodium, potassium, and rubidium are preferred. Those organic molecules or inorganic atoms may be used alone or in combination thereof.

The above-mentioned M represents a metal atom, and examples thereof include lead, tin, bismuth, zinc, titanium, antimony, nickel, iron, cobalt, silver, copper, gallium, germanium, magnesium, calcium, indium, aluminum, manganese, chromium, molybdenum, and europium. Among those, lead, tin, and bismuth are preferred from a viewpoint of the overlapping of electron orbits. Those metal atoms may be used alone or in combination thereof.

The above-mentioned X represents a halogen atom or a chalcogen atom, and examples thereof include chlorine, bromine, iodine, sulfur, and selenium. Those halogen atoms or chalcogen atoms may be used alone or in combination thereof. Among those, a halogen atom is preferred because, when the halogen atom is incorporated into the structure, the organic inorganic perovskite compound easily becomes soluble in an organic solvent, and hence the application to an inexpensive printing method or etc. is enabled. Further, iodine is more preferred because an energy bandgap of the organic inorganic perovskite compound narrows.

Specifically, MAPbI₃, Cs₅(MA_{0.17}FA_{0.83})₉₅Pb(I_{0.83}Br_{0.17})₃, or CsPbI₃ is preferred. "MA" represents methylammonium, and "FA" represents formamidinium.

The organic inorganic perovskite compound preferably has a cubic structure in which a metal atom M, organic molecules R, and a halogen atom or a chalcogen atom X are arranged on a body-centered position, the respective corners, and a face-centered position, respectively. Details are not clear, but it is assumed that, when the organic inorganic perovskite compound has such structure, an orientation of an octahedron in a crystal lattice can be easily changed, and hence the mobility of an electron in the organic inorganic perovskite compound increases, and the photoelectric conversion efficiency of the photoelectric conversion element is improved.

The organic inorganic perovskite compound to be used in the present invention is preferably a crystalline semiconductor. A term "crystalline semiconductor" means a semiconductor that enables measurement of an X-ray scattering intensity distribution to detect a scattering peak. When the organic inorganic perovskite compound is the crystalline semiconductor, the mobility of the electron in the organic inorganic perovskite compound increases, and the photoelectric conversion efficiency of the photoelectric conversion element is improved.

Thickness of the photoelectric conversion layer according to the present invention is preferably 5 nm or more and 1,000 nm or less. When the thickness is 5 nm or more, light can be sufficiently absorbed, and when the thickness is 1,000 nm or less, the generated charge can be transported to the respective electrodes. A more preferred lower limit is 10 nm or more, a more preferred upper limit is 700 nm, a still more preferred lower limit is 15 nm, and a still more preferred upper limit is 500 nm.

### [Charge-transporting Layer]

The photoelectric conversion element 1 of the present invention includes, between the photoelectric conversion layer 5 and the first electrode 7, the charge-transporting layer 8. **In** the present invention, the charge-transporting layer is preferably brought into contact with the photoelectric conversion layer. As described above, the charge-transporting layer 8 contains any one of: a phthalocyanine compound and an aromatic ring compound having a hydroxy group different from the phthalocyanine compound; or a hole-transportable compound and an aromatic ring compound having a calixarene structure.

Thickness of the charge-transporting layer 8 is preferably 20 nm or more and 800 nm or less. When the thickness is 20 nm or more, sufficient covering of the photoelectric conversion layer 5 is easy, and hence the charge transportation can be smoothly performed, and when the thickness is 800 nm or less, satisfactory charge transportation to the respective electrodes is easy. The thickness is more preferably 50 nm or more and 600 nm or less, still more preferably 50 nm or more and 400 nm or less.

### [Hole-transporting Layer]

In the present invention, the photoelectric conversion element 1 preferably includes, between the charge-transporting layer 8 and the first electrode 7, the hole-transporting layer 6 from a viewpoint of compatibility of a film of the charge-transporting layer.

A material for the hole-transporting layer 6 is not particularly limited, and examples thereof include a spirofluorene compound, a triphenylamine compound, a chrysene compound, a pyrene compound, a phthalocyanine compound, a carbazole compound, a fluorene compound, a phenylcyclohexane compound, a benzidine compound, a phenoxazine compound, a phenylenediamine compound, and a thiocyanate compound. The hole-transportable compound particularly preferably has an aromatic ring from a viewpoint of compatibility of a film interface, and Spiro-OMeTAD, PTAA, or a phthalocyanine compound are preferred as the hole-transportable compound.

### [Electron-transporting Layer]

In the photoelectric conversion element of in the present invention, the electron-transporting layer 4 may be arranged between the second electrode 3 and the photoelectric conversion layer 5 as illustrated in FIG. 1.

A material for the electron-transporting layer 4 is not particularly limited, and examples thereof include an N-type conductive polymer, an N-type low-molecular-weight organic semiconductor, an N-type metal oxide, an N-type metal sulfide, a halogenated alkali metal, an alkali metal, and a surfactant. Specific examples thereof include a cyano group-containing polyphenylene vinylene, a boron-containing polymer, bathocuproine, bathophenanthroline, hydroxyquinolinatoaluminum, an oxadiazole compound, a benzimidazole compound, a naphthalenetetracarboxylic acid compound, a perylene derivative, a phosphine oxide compound, a phosphine sulfide compound, a fluoro group-containing phthalocyanine, titanium oxide, zinc oxide, indium oxide, tin oxide, gallium oxide, tin sulfide, indium sulfide, and zinc sulfide.

A preferred lower limit of the thickness of the electron-transporting layer 4 is 1 nm, and a preferred upper limit thereof is 2,000 nm. When such thickness is 1 nm or more, a hole can be sufficiently blocked, and when the thickness is 2,000 nm or less, the electron-transporting layer 4 is less liable to serve as resistance at the time of the electron transportation, and hence photoelectric conversion efficiency increases. A more preferred lower limit of the thickness is 3 nm, a more preferred upper limit thereof is 1,000 nm, a still more preferred lower limit thereof is 5 nm, and a still more preferred upper limit thereof is 500 nm.

### [Photoelectric Conversion Apparatus]

A photoelectric conversion apparatus may be formed by using a plurality of photoelectric conversion elements of the present invention. When the plurality of photoelectric conversion elements are connected, such photoelectric conversion apparatus may also be referred to as "photoelectric conversion module." The photoelectric conversion elements may be laminated to increase an output voltage. In addition, the photoelectric conversion apparatus includes the photoelectric conversion element of the present invention and an inverter. The inverter may be a converter for converting a DC voltage to an AC voltage. The photoelectric conversion apparatus may include an electricity storage unit connected to the photoelectric conversion element. The electricity storage unit is not limited as long as the electricity storage unit can store electricity. Examples thereof include a secondary battery using a lithium ion or etc., an all-solid-state battery, and an electric double layer capacitor.

### <Application Example>

### [Moving Body]

A moving body of the present invention preferably includes the above-mentioned photoelectric conversion element. FIG. 3 is a perspective view for schematically illustrating an example of an application example as a moving body including the photoelectric conversion element of the present invention. A moving body 30 includes a photoelectric conversion element 31 of the present invention and a body 32 including the photoelectric conversion element 31. The photoelectric conversion element 31 is arranged on a position of the body 32 at which ambient light can be received. When the moving body 30 is an automobile, the photoelectric conversion element 31 may be arranged on a roof. Electric energy obtained by the photoelectric conversion element 31 may serve as power of the moving body 30 or power of any other electric equipment. Electric energy generated from the power of the moving body 30 may be used for power of the photoelectric conversion element 31. When the moving body 30 is an automobile, friction energy generated with a brake may be converted into electric energy to be used for the control of the photoelectric conversion element 31.

The moving body 30 may be, for example, an automobile, a ship, an aircraft, or a drone. The configuration of the body 32 of the moving body 30 is not particularly limited, but is preferably formed of a material having high strength.

### [Building Material]

A building material of the present invention preferably includes the above-mentioned photoelectric conversion element. FIG. 4 is a perspective view for schematically illustrating another example of an application example as a building material including the photoelectric conversion element of the present invention. A building material 40 may be a roof of a building. The building material 40 of the application example includes a photoelectric conversion element 41 of the present invention, a protective member 42 for protecting the photoelectric conversion element 41, a heat dissipation member 43, and exteriors 44a and 44b.

The building material 40 of the present invention may include the heat dissipation member 43 having a thermal conductivity higher than that of the photoelectric conversion element 41. When the building material 40 is used for a roof or etc., the temperature of the photoelectric conversion element 41 may be increased by sunlight, and hence the photoelectric conversion efficiency may be reduced. The reduction of the photoelectric conversion efficiency can be reduced by using the heat dissipation member 43. Examples of the heat dissipation member 43 include a metal, an alloy, a liquid metal, and a liquid resin.

In addition, the building material 40 of the present invention may include the exteriors 44a and 44b. The exterior 44a and the exterior 44b may show different colors, may be a same. The exteriors 44a and 44b may be formed of a same member or may be formed of different members. A paint or a transparent substrate may be used as the exterior. An exterior having small light absorption and a high heat-shielding property is preferred.

### [Examples]

The present invention is described in more detail below by way of Examples, but the present invention is not limited to these Examples. In addition, the term "part(s)" in the following description means "part(s) by mass" unless otherwise specified.

### [Production of Phthalocyanine Compound Particle]

### <Production of Particle 1>

### Step (1)

Under a nitrogen flow atmosphere, 5.46 parts of orthophthalonitrile and 45 parts of α-chloronaphthalene were loaded into a reaction kettle. After that, a mixture was heated so that its temperature was increased to 30°C, followed by the maintenance of the temperature. Next, 3.75 parts of gallium trichloride was loaded into the mixture at the temperature (30°C). The moisture concentration of the mixed liquid when the loading was 150 ppm. After that, a temperature of the mixed liquid was increased to 200°C. Next, under a nitrogen flow atmosphere, the mixed liquid was subjected to a reaction at a temperature of 200°C for 4.5 hours, and was then cooled. The product was filtered when its temperature reached 150°C. The resultant filter residue was subjected to dispersion washing with N,N-dimethylformamide at a temperature of 140°C for 2 hours, and was then filtered. The resultant filter residue was washed with methanol, and was then dried to provide a chlorogallium phthalocyanine particle in a yield of 71%.

### Step (2)

4.65 Parts of the chlorogallium phthalocyanine particle was dissolved in 139.5 parts of concentrated sulfuric acid at a temperature of 10°C, and the solution was dropped into 620 parts of ice water under stirring so that the particle was reprecipitated, followed by filtration with a filter press under reduced pressure. At this time, No. 5C (manufactured by Advantec Toyo Kaisha, Ltd.) was used as a filter. The resultant wet cake (filter residue) was subjected to dispersion washing with 2% ammonia water for 30 minutes, and was then filtered with the filter press. Next, the resultant wet cake (filter residue) was subjected to dispersion washing with ion-exchanged water, and then its filtration with the filter press was repeated three times. Finally, the filter residue was freeze-dried to provide a hydroxygallium phthalocyanine particle (hydrous hydroxygallium phthalocyanine particle) having a solid content of 23 mass% in a yield of 71%. The hydroxygallium phthalocyanine particle was dried with a hyper-dry dryer (product name: HD-06R, frequency (oscillatory frequency): 2,455 MHz±15 MHz, manufactured by Biocon (Japan) Ltd.). Thus, a hydroxygallium phthalocyanine particle (crystal) having a water content of 1.0 mass% or less was obtained.

### Step (3)

5 Parts of the hydroxygallium phthalocyanine (HOGaPc) particle was subjected to dispersion treatment with a sand mill (K-800, manufactured by Igarashi Machine Production Co., Ltd. (currently AIMEX Co., Ltd.), disc diameter: 70 mm, number of discs: 5) having loaded thereinto 5 parts of N,N-dimethylformamide (DMF) serving as a solvent and 5 parts of glass beads for 6 hours. The resultant was filtered and dried to provide a particle 1.

### (Example 1)

### [Formation of Electron-transporting Layer]

A glass substrate with indium tin oxide (ITO) was washed, and tin(II) oxide adjusted to 3 mass% was applied thereonto by spin coating. After that, the resultant was heated at 150°C for 30 minutes to form an electron-transporting layer as a thin film having a thickness of 100 nm.

### [Formation of Photoelectric Conversion Layer]

4 Grams of lead iodide and 1.4 g of methylammonium iodide were dissolved in 4.5 g of dimethylformamide serving as a solvent, and the solution was stirred at 60°C for 24 hours to prepare a coating liquid for a photoelectric conversion layer. The coating liquid was applied onto the electron-transporting layer by spin coating to form a photoelectric conversion layer formed of MAPbI₃ having a thickness of 500 nm.

### [Formation of Charge-transporting Layer]

0.05 Gram of the particle 1 was subjected to dispersion treatment with a sand mill (K-800, manufactured by Igarashi Machine Production Co., Ltd. (currently AIMEX Co., Ltd.), disc diameter: 70 mm, number of discs: 5) having loaded thereinto 4.95 g of 2-propanol serving as a solvent, 0.0001 g of phenol serving as an aromatic ring compound having a hydroxy group, and 11 g of glass beads for 6 hours to prepare a charge-transporting layer solution. The charge-transporting layer solution was applied onto the photoelectric conversion layer by spin coating to form a charge-transporting layer having a thickness of 100 nm.

### [Introduction of Hole-transporting Layer]

180 Milligrams of Spiro-OMeTAD serving as a hole-transportable compound was dissolved in 1 mL of chlorobenzene. 37.5 Microliters of an acetonitrile solution obtained by dissolving 170 mg of lithium-bis(trifluoromethanesulfonyl)imide in 1 mL of acetonitrile and 17.5 µL of t-butylpyridine (TBP) were added to the chlorobenzene solution, and the contents were mixed to prepare a solution of the hole-transportable compound. The solution was applied onto the charge-transporting layer by a spin coating method to form a hole-transporting layer having a thickness of 200 nm.

### [Formation of First Electrode]

A gold electrode having a thickness of 80 nm and an area of 0.09 cm² was formed on the hole-transporting layer by a vacuum vapor deposition method. Thus, a photoelectric conversion element was obtained.

### (Examples 2 to 5)

Photoelectric conversion elements were obtained in a same manner as in Example 1 except that 0.00025 g, 0.005 g, 0.025 g, and 0.04 g of the aromatic ring compound having a hydroxy group were used in Example 2, Example 3, Example 4, and Example 5, respectively.

### (Examples 6 to 8)

Photoelectric conversion elements were obtained in a same manner as in Example 1 except that the aromatic ring compound having a hydroxy group was changed to 1-naphthol, and 0.0001 g, 0.00025 g, and 0.025 g thereof were used in Example 6, Example 7, and Example 8, respectively.

### (Examples 9 to 12)

Photoelectric conversion elements were obtained in a same manner as in Example 1 except that the aromatic ring compound having a hydroxy group was changed to the aromatic ring compound represented by the formula [C-1], and 0.0001 g, 0.00025 g, 0.0025 g, and 0.005 g thereof were used in Example 9, Example 10, Example 11, and Example 12, respectively.

### (Example 13)

A photoelectric conversion element was obtained in a same manner as in Example 1 except that: the aromatic ring compound having a hydroxy group was changed to the aromatic ring compound represented by the formula [C-1] and 0.005 g thereof was used; and the hole-transportable compound of the hole-transporting layer was changed to PTAA (CAS: 1333317-99-9, manufactured by Luminescence Technology Corp.).

### (Example 14)

A photoelectric conversion element was obtained in a same manner as in Example 1 except that: the aromatic ring compound having a hydroxy group was changed to the aromatic ring compound represented by the formula [C-1] and 0.005 g thereof was used; and the crystal having a perovskite structure was changed to Cs₅(MA_{0.17}FA_{0.83})₉₅Pb(I_{0.83}Br_{0.17})₃.

### (Examples 15 to 17)

Photoelectric conversion elements were obtained in a same manner as in Example 1 except that: the aromatic ring compound having a hydroxy group was changed to the aromatic ring compound represented by the formula [C-1], and 0.015 g, 0.025 g, and 0.04 g thereof were used in Example 15, Example 16, and Example 17, respectively.

### (Example 18)

A photoelectric conversion element was obtained in a same manner as in Example 1 except that the aromatic ring compound having a hydroxy group was changed to the aromatic ring compound represented by the formula [C-9] and 0.005 g thereof was used.

### (Example 19)

A photoelectric conversion element was obtained in a same manner as in Example 1 except that 0.005 g of a product obtained by mixing the aromatic ring compound represented by the formula [C-1] and the aromatic ring compound represented by the formula [C-2] at a mass ratio of 1:1 was used as the aromatic ring compound having a hydroxy group.

### (Examples 20 to 22)

Photoelectric conversion elements were obtained in a same manner as in Example 1 except that: the aromatic ring compound having a hydroxy group was changed to a product obtained by mixing the aromatic ring compounds represented by the formulae [C-1] to [C-4], respectively, and 0.0001 g, 0.00025 g, and 0.005 g thereof were used in Example 20, Example 21, and Example 22, respectively. A mass ratio was set to [C-1]:[C-2]:[C-3]:[C-4]=1:1:1:1.

### (Example 23)

A photoelectric conversion element was obtained in a same manner as in Example 1 except that: the aromatic ring compound having a hydroxy group was changed to a product obtained by mixing the aromatic ring compounds represented by the formulae [C-1] to [C-4], respectively, and 0.005 g thereof was used; and the crystal having a perovskite structure was changed to Sr₂Nb₂O₇. A mass ratio was set to [C-1]:[C-2]:[C-3]:[C-4]=1:1:1:1.

### (Example 24)

A photoelectric conversion element was obtained in a same manner as in Example 1 except that: the aromatic ring compound having a hydroxy group was changed to a product obtained by mixing the aromatic ring compounds represented by the formulae [C-1] to [C-4], respectively, and 0.005 g thereof was used; and the hole-transporting layer was not formed. A mass ratio was set to [C-1]:[C-2]:[C-3]:[C-4]=1:1:1:1.

### (Example 25)

A photoelectric conversion element was obtained in a same manner as in Example 1 except that: the aromatic ring compound having a hydroxy group was changed to a product obtained by mixing the aromatic ring compounds represented by the formulae [C-1] to [C-4], respectively, and 0.005 g thereof was used; and the film formation order of the hole-transporting layer and the charge-transporting layer was changed to be reversed so that the hole-transporting layer was brought into contact with the photoelectric conversion layer. A mass ratio was set to [C-1]:[C-2]:[C-3]:[C-4]=1:1:1:1.

### (Examples 26 and 27)

Photoelectric conversion elements were obtained in a same manner as in Example 1 except that the aromatic ring compound having a hydroxy group was changed to a product obtained by mixing the aromatic ring compounds represented by the formulae [C-1] to [C-4], respectively, and 0.025 g and 0.04 g thereof were used in Example 26 and Example 27, respectively. A mass ratio was set to [C-1]:[C-2]:[C-3]:[C-4]=1:1:1:1.

### (Example 28)

A photoelectric conversion element was obtained in a same manner as in Example 1 except that the aromatic ring compound having a hydroxy group was changed to an aromatic ring compound represented by the following formula [A-1] (CAS: 490-46-0, manufactured by FUJIFILM Corporation) and an aromatic ring compound represented by the following formula [A-2] (CAS: 970-73-0, manufactured by FUJIFILM Corporation), and 0.005 g thereof was used. A mass ratio was set to [A-1]:[A-2]=1:1.

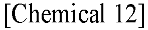

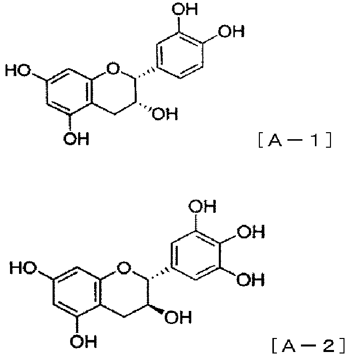

### (Example 29)

A photoelectric conversion element was obtained in a same manner as in Example 1 except that 0.005 g of a product obtained by mixing the aromatic ring compound represented by the formula [C-5] and the aromatic ring compound represented by the formula [C-6] at a mass ratio of 1:1 was used as the aromatic ring compound having a hydroxy group.

### (Example 30)

A photoelectric conversion element was obtained in a same manner as in Example 1 except that 0.005 g of a product obtained by mixing the aromatic ring compound represented by the formula [C-7] and the aromatic ring compound represented by the formula [C-8] at a mass ratio of 1:1 was used as the aromatic ring compound having a hydroxy group.

### (Examples 31 to 33)

Photoelectric conversion elements were obtained in a same manner as in Example 1 except that: the phthalocyanine compound was changed to copper phthalocyanine (CuPc); and 0.0001 g, 0.005 g, and 0.04 g of the aromatic ring compound having a hydroxy group were used in Example 31, Example 32, and Example 33, respectively.

### (Examples 34 and 35)

Photoelectric conversion elements were obtained in a same manner as in Example 1 except that: the phthalocyanine compound was changed to copper phthalocyanine; and the aromatic ring compound having a hydroxy group was changed to 1-naphthol, and 0.00025 g and 0.025 g thereof were used in Example 34 and Example 35, respectively.

### (Examples 36 to 38)

Photoelectric conversion elements were obtained in a same manner as in Example 1 except that: the phthalocyanine compound was changed to copper phthalocyanine; and the aromatic ring compound having a hydroxy group was changed to the aromatic ring compound represented by the formula [C-1], and 0.0001 g, 0.0025 g, and 0.005 g thereof were used in Example 36, Example 37, and Example 38, respectively.

### (Example 39)

A photoelectric conversion element was obtained in a same manner as in Example 1 except that: the phthalocyanine compound was changed to copper phthalocyanine; the aromatic ring compound having a hydroxy group was changed to the aromatic ring compound represented by the formula [C-1] and 0.005 g thereof was used; and the hole-transportable compound was changed to PTAA.

### (Example 40)

A photoelectric conversion element was obtained in a same manner as in Example 1 except that: the phthalocyanine compound was changed to copper phthalocyanine; the aromatic ring compound having a hydroxy group was changed to the aromatic ring compound represented by the formula [C-1] and 0.005 g thereof was used; and the crystal having a perovskite structure was changed to Cs₅(MA_{0.17}FA_{0.83})₉₅Pb(I_{0.83}Br_{0.17})₃.

### (Examples 41 and 42)

Photoelectric conversion elements were obtained in a same manner as in Example 1 except that: the phthalocyanine compound was changed to copper phthalocyanine; and the aromatic ring compound having a hydroxy group was changed to the aromatic ring compound represented by the formula [C-1], and 0.015 g and 0.04 g thereof were used in Example 41 and Example 42, respectively.

### (Example 43)

A photoelectric conversion element was obtained in a same manner as in Example 1 except that: the phthalocyanine compound was changed to copper phthalocyanine; and the aromatic ring compound having a hydroxy group was changed to the aromatic ring compound represented by the formula [C-9] and 0.005 g thereof was used.

### (Examples 44 and 45)

Photoelectric conversion elements were obtained in a same manner as in Example 1 except that: the phthalocyanine compound was changed to copper phthalocyanine; and the aromatic ring compound having a hydroxy group was changed to a product obtained by mixing the aromatic ring compounds represented by the formulae [C-1] to [C-4], respectively, and 0.00025 g and 0.025 g thereof were used in Example 44 and Example 45, respectively. The mass ratio was set to [C-1]:[C-2]:[C-3]:[C-4]=1:1:1:1.

### (Examples 46 to 48)

Photoelectric conversion elements were obtained in a same manner as in Example 1 except that: the phthalocyanine compound was changed to zinc phthalocyanine (ZnPc); and 0.0001 g, 0.005 g, and 0.04 g of the aromatic ring compound having a hydroxy group were used in Example 46, Example 47, and Example 48, respectively.

### (Examples 49 and 50)

Photoelectric conversion elements were obtained in a same manner as in Example 1 except that: the phthalocyanine compound was changed to zinc phthalocyanine; and the aromatic ring compound having a hydroxy group was changed to 1-naphthol, and 0.00025 g and 0.025 g thereof were used in Example 49 and Example 50, respectively.

### (Examples 51 to 53)

Photoelectric conversion elements were obtained in a same manner as in Example 1 except that: the phthalocyanine compound was changed to zinc phthalocyanine; and the aromatic ring compound having a hydroxy group was changed to the aromatic ring compound represented by the formula [C-1], and 0.0001 g, 0.0025 g, and 0.005 g thereof were used in Example 51, Example 52, and Example 53, respectively.

### (Example 54)

A photoelectric conversion element was obtained in a same manner as in Example 1 except that: the phthalocyanine compound was changed to zinc phthalocyanine; the aromatic ring compound having a hydroxy group was changed to the aromatic ring compound represented by the formula [C-1] and 0.005 g thereof was used; and the hole-transportable compound of the hole-transporting layer was changed to PTAA.

### (Example 55)

A photoelectric conversion element was obtained in a same manner as in Example 1 except that: the phthalocyanine compound was changed to zinc phthalocyanine; the aromatic ring compound having a hydroxy group was changed to the aromatic ring compound represented by the formula [C-1] and 0.005 g thereof was used; and the crystal having a perovskite structure was changed to Cs₅(MA_{0.17}FA_{0.83})₉₅Pb(I_{0.83}Br_{0.17})₃.

### (Examples 56 and 57)

Photoelectric conversion elements were obtained in a same manner as in Example 1 except that: the phthalocyanine compound was changed to zinc phthalocyanine; and the aromatic ring compound having a hydroxy group was changed to the aromatic ring compound represented by the formula [C-1], and 0.015 g and 0.04 g thereof were used in Example 56 and Example 57, respectively.

### (Example 58)

A photoelectric conversion element was obtained in a same manner as in Example 1 except that: the phthalocyanine compound was changed to zinc phthalocyanine; and the aromatic ring compound having a hydroxy group was changed to the aromatic ring compound represented by the formula [C-9] and 0.005 g thereof was used.

### (Examples 59 and 60)

Photoelectric conversion elements were obtained in a same manner as in Example 1 except that: the phthalocyanine compound was changed to zinc phthalocyanine; and the aromatic ring compound having a hydroxy group was changed to a product obtained by mixing the aromatic ring compounds represented by the formulae [C-1] to [C-4], respectively, and 0.00025 g and 0.025 g thereof were used in Example 59 and Example 60, respectively. A mass ratio was set to [C-1]:[C-2]:[C-3]:[C-4]=1:1:1:1.

### (Examples 61 to 63)

Photoelectric conversion elements were obtained in a same manner as in Example 1 except that: the phthalocyanine compound was changed to titanyl phthalocyanine (TiPc); and 0.0001 g, 0.005 g, and 0.04 g of the aromatic ring compound having a hydroxy group were used in Example 61, Example 62, and Example 63, respectively.

### (Examples 64 and 65)

Photoelectric conversion elements were obtained in a same manner as in Example 1 except that: the phthalocyanine compound was changed to titanyl phthalocyanine; and the aromatic ring compound having a hydroxy group was changed to 1-naphthol, and 0.00025 g and 0.025 g thereof were used in Example 64 and Example 65, respectively.

### (Examples 66 to 68)

Photoelectric conversion elements were obtained in a same manner as in Example 1 except that: the phthalocyanine compound was changed to titanyl phthalocyanine; and the aromatic ring compound having a hydroxy group was changed to the aromatic ring compound represented by the formula [C-1], and 0.0001 g, 0.0025 g, and 0.005 g thereof were used in Example 66, Example 67, and Example 68, respectively.

### (Example 69)

A photoelectric conversion element was obtained in a same manner as in Example 1 except that: the phthalocyanine compound was changed to titanyl phthalocyanine; the aromatic ring compound having a hydroxy group was changed to the aromatic ring compound represented by the formula [C-1] and 0.005 g thereof was used; and the hole-transportable compound of the hole-transporting layer was changed to PTAA.

### (Example 70)

A photoelectric conversion element was obtained in a same manner as in Example 1 except that: the phthalocyanine compound was changed to titanyl phthalocyanine; the aromatic ring compound having a hydroxy group was changed to the aromatic ring compound represented by the formula [C-1] and 0.005 g thereof was used; and the crystal having a perovskite structure was changed to Cs₅(MA_{0.17}FA_{0.83})₉₅Pb(I_{0.83}Br_{0.17})₃.

### (Examples 71 and 72)

Photoelectric conversion elements were obtained in a same manner as in Example 1 except that: the phthalocyanine compound was changed to titanyl phthalocyanine; and the aromatic ring compound having a hydroxy group was changed to the aromatic ring compound represented by the formula [C-1], and 0.015 g and 0.04 g thereof were used in Example 71 and Example 72, respectively.

### (Example 73)

A photoelectric conversion element was obtained in a same manner as in Example 1 except that: the phthalocyanine compound was changed to titanyl phthalocyanine; and the aromatic ring compound having a hydroxy group was changed to the aromatic ring compound represented by the formula [C-9] and 0.005 g thereof was used.

### (Examples 74 and 75)

Photoelectric conversion elements were obtained in a same manner as in Example 1 except that: the phthalocyanine compound was changed to titanyl phthalocyanine; and the aromatic ring compound having a hydroxy group was changed to a product obtained by mixing the aromatic ring compounds represented by the formulae [C-1] to [C-4], respectively, and 0.00025 g and 0.025 g thereof were used in Example 74 and Example 75, respectively. A mass ratio was set to [C-1]:[C-2]:[C-3]:[C-4]=1:1:1:1.

### (Examples 76 to 78)

Photoelectric conversion elements were obtained in a same manner as in Example 1 except that: the phthalocyanine compound was changed to chlorogallium phthalocyanine (ClGaPc); and 0.0001 g, 0.005 g, and 0.04 g of the aromatic ring compound having a hydroxy group were used in Example 76, Example 77, and Example 78, respectively.

### (Examples 79 and 80)

Photoelectric conversion elements were obtained in a same manner as in Example 1 except that: the phthalocyanine compound was changed to chlorogallium phthalocyanine; and the aromatic ring compound having a hydroxy group was changed to 1-naphthol, and 0.00025 g and 0.025 g thereof were used in Example 79 and Example 80, respectively.

### (Examples 81 and 82)

Photoelectric conversion elements were obtained in a same manner as in Example 1 except that: the phthalocyanine compound was changed to chlorogallium phthalocyanine; and the aromatic ring compound having a hydroxy group was changed to the aromatic ring compound represented by the formula [C-1], and 0.0001 g and 0.005 g thereof were used in Example 81 and Example 82, respectively.

### (Example 83)

A photoelectric conversion element was obtained in a same manner as in Example 1 except that: the phthalocyanine compound was changed to chlorogallium phthalocyanine; the aromatic ring compound having a hydroxy group was changed to the aromatic ring compound represented by the formula [C-1] and 0.005 g thereof was used; and the hole-transportable compound of the hole-transporting layer was changed to PTAA.

### (Example 84)

A photoelectric conversion element was obtained in a same manner as in Example 1 except that: the phthalocyanine compound was changed to chlorogallium phthalocyanine; the aromatic ring compound having a hydroxy group was changed to the aromatic ring compound represented by the formula [C-1] and 0.005 g thereof was used; and the crystal having a perovskite structure was changed to Cs₅(MA_{0.17}FA_{0.83})₉₅Pb(I_{0.83}Br_{0.17})₃.

### (Example 85)

A photoelectric conversion element was obtained in a same manner as in Example 1 except that: the phthalocyanine compound was changed to chlorogallium phthalocyanine; and the aromatic ring compound having a hydroxy group was changed to the aromatic ring compound represented by the formula [C-1] and 0.04 g thereof was used.

### (Example 86)

A photoelectric conversion element was obtained in a same manner as in Example 1 except that: the phthalocyanine compound was changed to chlorogallium phthalocyanine; and the aromatic ring compound having a hydroxy group was changed to the aromatic ring compound represented by the formula [C-9] and 0.005 g thereof was used.

### (Examples 87 and 88)

Photoelectric conversion elements were obtained in a same manner as in Example 1 except that: the phthalocyanine compound was changed to chlorogallium phthalocyanine; and the aromatic ring compound having a hydroxy group was changed to a product obtained by mixing the aromatic ring compounds represented by the formulae [C-1] to [C-4], respectively, and 0.00025 g and 0.025 g thereof were used in Example 87 and Example 88, respectively. The mass ratio was set to [C-1]:[C-2]:[C-3]:[C-4]=1:1:1:1.

### (Example 89)

A photoelectric conversion element was obtained in a same manner as in Example 1 except that: the phthalocyanine compound was changed to a metal-free phthalocyanine (Pc); and the aromatic ring compound having a hydroxy group was changed to a product obtained by mixing the aromatic ring compounds represented by the formulae [C-1] to [C-4], respectively, and 0.005 g thereof was used. A mass ratio was set to [C-1]:[C-2]:[C-3]:[C-4]=1:1:1:1.

### (Example 90)

A photoelectric conversion element was obtained in a same manner as in Example 1 except that: the phthalocyanine compound was changed to gallium phthalocyanine represented by the following formula [F-1]; and the aromatic ring compound having a hydroxy group was changed to a product obtained by mixing the aromatic ring compounds represented by the formulae [C-1] to [C-4], respectively, and 0.005 g thereof was used. A mass ratio was set to [C-1]:[C-2]:[C-3]:[C-4]=1:1:1:1.

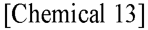

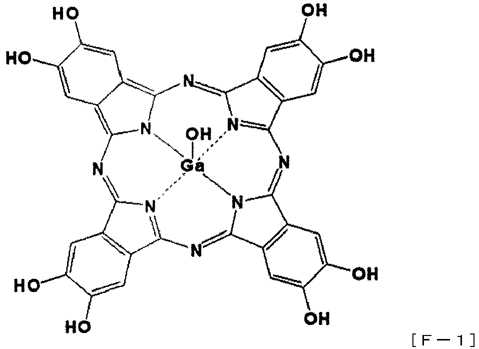

### (Comparative Example 1)

A photoelectric conversion element was obtained in a same manner as in Example 1 except that: the phthalocyanine compound was changed to zinc phthalocyanine; and the aromatic ring compound having a hydroxy group was not used.

### (Comparative Example 2)

A photoelectric conversion element was obtained in a same manner as in Example 1 except that: the phthalocyanine compound was changed to titanyl phthalocyanine; and the aromatic ring compound having a hydroxy group was not used.

### (Comparative Example 3)

A photoelectric conversion element was obtained in a same manner as in Example 1 except that the phthalocyanine compound was not used.

### (Comparative Example 4)

A photoelectric conversion element was obtained in a same manner as in Example 1 except that: the phthalocyanine compound was not used; and the aromatic ring compound having a hydroxy group was changed to the aromatic ring compound represented by the formula [C-1].

### (Comparative Example 5)

A photoelectric conversion element was obtained in a same manner as in Example 1 except that: the phthalocyanine compound was not used; and the aromatic ring compound having a hydroxy group was changed to a product obtained by mixing the aromatic ring compounds represented by the formulae [C-1] to [C-4], respectively. A mass ratio was set to [C-1]:[C-2]:[C-3]:[C-4]=1:1:1:1.

### (Examples 91 to 93)

Photoelectric conversion elements were obtained in a same manner as in Example 1 except that: the phthalocyanine compound was changed to Spiro-OMeTAD serving as the hole-transportable compound; and the aromatic ring compound having a hydroxy group was changed to the aromatic ring compound represented by the formula [C-1], and 0.00025 g, 0.005 g, and 0.025 g thereof were used in Example 91, Example 92, and Example 93, respectively.

### (Example 94)

A photoelectric conversion element was obtained in a same manner as in Example 1 except that: the phthalocyanine compound was changed to Spiro-OMeTAD serving as the hole-transportable compound; and the aromatic ring compound having a hydroxy group was changed to a product obtained by mixing the aromatic ring compounds represented by the formulae [C-1] to [C-4], respectively, and 0.005 g thereof was used. A mass ratio was set to [C-1]:[C-2]:[C-3]:[C-4]=1:1:1:1.

### (Comparative Example 6)

A photoelectric conversion element was obtained in a same manner as in Example 1 except that the phthalocyanine compound was changed to Spiro-OMeTAD serving as the hole-transportable compound and 0.0001 g thereof was used.

### (Comparative Example 7)

A photoelectric conversion element was obtained in a same manner as in Example 1 except that the phthalocyanine compound was changed to Spiro-OMeTAD serving as the hole-transportable compound and 0.04 g thereof was used.

### [Evaluation]

The photoelectric conversion element obtained in each of Examples and Comparative Examples was subjected to the following evaluation.

### (Power Generation Efficiency Evaluation)

A power source (manufactured by Keithley Instruments, Model 236) was connected between the electrodes of the photoelectric conversion element, and constant light was applied with a solar simulator (manufactured by Yamashita Denso Corporation) at an intensity of 100 mW/cm², and a current and a voltage to be generated were measured. Thus, photoelectric conversion efficiency was evaluated. A deterioration evaluation was performed by continuously applying 2,000 Lx light and measuring the photoelectric conversion efficiency after 30 days. Stability of the element was evaluated with an attenuation rate of the conversion efficiency after 30 days with respect to initial conversion efficiency (deterioration rate after 30 days). Results are shown in Table 1 to Table 4. The term "Usage amount" in "Aromatic ring compound having hydroxy group" in each of the tables represents the usage amount (part(s) by mass) of the aromatic ring compound when the usage amount of the phthalocyanine compound is set to 100 parts by mass.

### [Table 1]

**Table 1**

| | Phthalocyanine compound | Aromatic ring compound having hydroxy group | | Initial conversion efficiency [%] | Deterioration rate after 30 days [%] |
|---|---|---|---|---|---|
| | | Compound | Usage amount [part(s) by mass] | | |
| Example 1 | HOGaPc | Phenol | 0.2 | 16.2 | 34 |
| Example 2 | HOGaPc | Phenol | 0.5 | 16.1 | 23 |
| Example 3 | HOGaPc | Phenol | 10.0 | 16.0 | 20 |
| Example 4 | HOGaPc | Phenol | 50.0 | 15.1 | 25 |
| Example 5 | HOGaPc | Phenol | 80.0 | 14.4 | 36 |
| Example 6 | HOGaPc | 1-Naphthol | 0.2 | 16.2 | 34 |
| Example 7 | HOGaPc | 1-Naphthol | 0.5 | 16.0 | 23 |
| Example 8 | HOGaPc | 1-Naphthol | 50.0 | 15.2 | 25 |
| Example 9 | HOGaPc | C-1 | 0.2 | 16.4 | 31 |
| Example 10 | HOGaPc | C-1 | 0.5 | 16.2 | 21 |
| Example 11 | HOGaPc | C-1 | 5.0 | 16.1 | 16 |
| Example 12 | HOGaPc | C-1 | 10.0 | 16.1 | 12 |
| Example 13 | HOGaPc | C-1 | 10.0 | 16.0 | 12 |
| Example 14 | HOGaPc | C-1 | 10.0 | 16.2 | 13 |
| Example 15 | HOGaPc | C-1 | 30.0 | 15.8 | 15 |
| Example 16 | HOGaPc | C-1 | 50.0 | 15.5 | 17 |
| Example 17 | HOGaPc | C-1 | 80.0 | 14.8 | 33 |
| Example 18 | HOGaPc | C-9 | 10.0 | 16.0 | 11 |
| Example 19 | HOGaPc | C-1, C-2 | 10.0 | 16.0 | 8 |
| Example 20 | HOGaPc | C-1, C-2, C-3, C-4 | 0.2 | 16.3 | 29 |
| Example 21 | HOGaPc | C-1, C-2, C-3, C-4 | 0.5 | 16.2 | 18 |
| Example 22 | HOGaPc | C-1, C-2, C-3, C-4 | 10.0 | 16.2 | 5 |
| Example 23 | HOGaPc | C-1, C-2, C-3, C-4 | 10.0 | 8.3 | 41 |
| Example 24 | HOGaPc | C-1, C-2, C-3, C-4 | 10.0 | 9.6 | 26 |
| Example 25 | HOGaPc | C-1, C-2, C-3, C-4 | 10.0 | 5.5 | 51 |
| Example 26 | HOGaPc | C-1, C-2, C-3, C-4 | 50.0 | 15.6 | 16 |
| Example 27 | HOGaPc | C-1, C-2, C-3, C-4 | 80.0 | 14.9 | 31 |
| Example 28 | HOGaPc | A-1, A-2 | 10.0 | 15.9 | 19 |
| Example 29 | HOGaPc | C-5, C-6 | 10.0 | 15.8 | 11 |
| Example 30 | HOGaPc | C-7, C-8 | 10.0 | 16.0 | 17 |

### [Table 2]

**Table 2**

| | Phthalocyanine compound | Aromatic ring compound having hydroxy group | | Initial conversion efficiency [%] | Deterioration rate after 30 days [%] |
|---|---|---|---|---|---|
| | | Compound | Usage amount [part(s) by mass] | | |
| Example 31 | CuPc | Phenol | 0.2 | 15.2 | 38 |
| Example 32 | CuPc | Phenol | 10.0 | 14.6 | 23 |
| Example 33 | CuPc | Phenol | 80.0 | 13.2 | 39 |
| Example 34 | CuPc | 1-Naphthol | 0.5 | 15.0 | 26 |
| Example 35 | CuPc | 1-Naphthol | 50.0 | 14.6 | 30 |
| Example 36 | CuPc | C-1 | 0.2 | 15.4 | 35 |
| Example 37 | CuPc | C-1 | 5.0 | 15.3 | 19 |
| Example 38 | CuPc | C-1 | 10.0 | 15.2 | 16 |
| Example 39 | CuPc | C-1 | 10.0 | 14.9 | 16 |
| Example 40 | CuPc | C-1 | 10.0 | 15.3 | 15 |
| Example 41 | CuPc | C-1 | 30.0 | 14.5 | 19 |
| Example 42 | CuPc | C-1 | 80.0 | 13.6 | 36 |
| Example 43 | CuPc | C-9 | 10.0 | 15.3 | 14 |
| Example 44 | CuPc | C-1, C-2, C-3, C-4 | 0.5 | 15.4 | 23 |
| Example 45 | CuPc | C-1, C-2, C-3, C-4 | 50.0 | 15.0 | 19 |
| Example 46 | ZnPc | Phenol | 0.2 | 15.3 | 40 |
| Example 47 | ZnPc | Phenol | 10.0 | 14.7 | 29 |
| Example 48 | ZnPc | Phenol | 80.0 | 13.4 | 42 |
| Example 49 | ZnPc | 1-Naphthol | 0.5 | 15.2 | 28 |
| Example 50 | ZnPc | 1-Naphthol | 50.0 | 14.7 | 32 |
| Example 51 | ZnPc | C-1 | 0.2 | 15.5 | 38 |
| Example 52 | ZnPc | C-1 | 5.0 | 15.5 | 23 |
| Example 53 | ZnPc | C-1 | 10.0 | 15.3 | 20 |
| Example 54 | ZnPc | C-1 | 10.0 | 15.0 | 20 |
| Example 55 | ZnPc | C-1 | 10.0 | 15.4 | 19 |
| Example 56 | ZnPc | C-1 | 30.0 | 14.7 | 22 |
| Example 57 | ZnPc | C-1 | 80.0 | 13.7 | 39 |
| Example 58 | ZnPc | C-9 | 10.0 | 15.5 | 18 |
| Example 59 | ZnPc | C-1, C-2, C-3, C-4 | 0.5 | 15.6 | 25 |
| Example 60 | ZnPc | C-1, C-2, C-3, C-4 | 50.0 | 15.0 | 24 |

### [Table 3]

**Table 3**

| | Phthalocyanine compound | Aromatic ring compound having hydroxy group | | Initial conversion efficiency [%] | Deterioration rate after 30 days [%] |
|---|---|---|---|---|---|
| | | Compound | Usage amount [part(s) by mass] | | |
| Example 61 | TiPc | Phenol | 0.2 | 13.2 | 44 |
| Example 62 | TiPc | Phenol | 10.0 | 12.9 | 33 |
| Example 63 | TiPc | Phenol | 80.0 | 11.5 | 45 |
| Example 64 | TiPc | 1-Naphthol | 0.5 | 13.4 | 30 |
| Example 65 | TiPc | 1-Naphthol | 50.0 | 12.7 | 35 |
| Example 66 | TiPc | C-1 | 0.2 | 13.7 | 41 |
| Example 67 | TiPc | C-1 | 5.0 | 13.6 | 28 |
| Example 68 | TiPc | C-1 | 10.0 | 13.5 | 25 |
| Example 69 | TiPc | C-1 | 10.0 | 13.2 | 25 |
| Example 70 | TiPc | C-1 | 10.0 | 13.6 | 23 |
| Example 71 | TiPc | C-1 | 30.0 | 13.0 | 28 |
| Example 72 | TiPc | C-1 | 80.0 | 11.8 | 42 |
| Example 73 | TiPc | C-9 | 10.0 | 13.6 | 24 |
| Example 74 | TiPc | C-1, C-2, C-3, C-4 | 0.5 | 13.8 | 29 |
| Example 75 | TiPc | C-1, C-2, C-3, C-4 | 50.0 | 13.1 | 27 |
| Example 76 | ClGaPc | Phenol | 0.2 | 15.3 | 35 |
| Example 77 | ClGaPc | Phenol | 10.0 | 15.0 | 21 |
| Example 78 | ClGaPc | Phenol | 80.0 | 13.8 | 40 |
| Example 79 | ClGaPc | 1-Naphthol | 0.5 | 15.5 | 24 |
| Example 80 | ClGaPc | 1-Naphthol | 50.0 | 14.9 | 27 |
| Example 81 | ClGaPc | C-1 | 0.2 | 15.7 | 33 |
| Example 82 | ClGaPc | C-1 | 10.0 | 15.6 | 14 |
| Example 83 | ClGaPc | C-1 | 10.0 | 15.5 | 14 |
| Example 84 | ClGaPc | C-1 | 10.0 | 15.7 | 13 |
| Example 85 | ClGaPc | C-1 | 80.0 | 14.1 | 34 |
| Example 86 | ClGaPc | C-9 | 10.0 | 15.7 | 13 |
| Example 87 | ClGaPc | C-1, C-2, C-3, C-4 | 0.5 | 15.7 | 20 |
| Example 88 | ClGaPc | C-1, C-2, C-3, C-4 | 50.0 | 15.4 | 18 |
| Example 89 | Pc | C-1, C-2, C-3, C-4 | 10.0 | 12.6 | 35 |
| Example 90 | F-1 | C-1, C-2, C-3, C-4 | 10.0 | 14.3 | 31 |
| Comparative Example 1 | ZnPc | - | - | 13.8 | 79 |
| Comparative Example 2 | TiPc | - | - | 12.6 | 82 |
| Comparative Example 3 | - | Phenol | - | 7.6 | 69 |
| Comparative Example 4 | - | C-1 | - | 8.5 | 65 |

### [Table 4]

**Table 4**

| | Hole-transportable compound | Aromatic ring compound having hydroxy group | | Initial conversion efficiency [%] | Deterioration rate after 30 days [%] |
|---|---|---|---|---|---|
| | | Compound | Usage amount [part(s) by mass] | | |
| Example 91 | Spiro-OMeTAD | C-1 | 0.5 | 10.9 | 40 |
| Example 92 | Spiro-OMeTAD | C-1 | 10.0 | 10.9 | 34 |
| Example 93 | Spiro-OMeTAD | C-1 | 50.0 | 10.1 | 38 |
| Example 94 | Spiro-OMeTAD | C-1, C-2, C-3, C-4 | 10.0 | 11.1 | 35 |
| Comparative Example 6 | Spiro-OMeTAD | Phenol | 0.2 | 10.8 | 52 |
| Comparative Example 7 | Spiro-OMeTAD | Phenol | 80.0 | 9.1 | 52 |

The present invention is not limited to the embodiments described above, and various changes and modifications may be made without departing from the spirit and scope of the present invention. The following claims are appended hereto in order to make the scope of the present invention public.

The present application claims priority based on Japanese Patent Application No. 2022-167637 filed on October 19, 2022 and Japanese Patent Application No. 2023-158475 filed on September 22, 2023, and the entire contents thereof are incorporated herein by reference.

### [Reference Signs List]

1 photoelectric conversion element
2 substrate
3 second electrode
4 electron-transporting layer
5 photoelectric conversion layer
6 hole-transporting layer
7 first electrode
8 charge-transporting layer

## Claims

1. A photoelectric conversion element comprising:
a first electrode;
a second electrode; and
a photoelectric conversion layer containing a crystal having a perovskite structure arranged between the first electrode and the second electrode,
wherein the photoelectric conversion element comprises a charge-transporting layer containing a phthalocyanine compound and an aromatic ring compound having a hydroxy group different from the phthalocyanine compound between the photoelectric conversion layer and the first electrode.

2. The photoelectric conversion element according to claim 1, wherein a number of hydroxy groups in the aromatic ring compound is larger than the number of hydroxy groups in the phthalocyanine compound.

3. The photoelectric conversion element according to claim 1 or 2, wherein a number of hydroxy groups in the aromatic ring compound is 3 or more.

4. The photoelectric conversion element according to claim 1 or 2, wherein a number of hydroxy groups in the aromatic ring compound is 4 or more.

5. The photoelectric conversion element according to any one of claims 1 to 4, wherein the charge-transporting layer contains a plurality of kinds of the aromatic ring compound.

6. The photoelectric conversion element according to any one of claims 1 to 5, wherein the aromatic ring compound is a compound represented by the following general formula [1]: 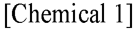 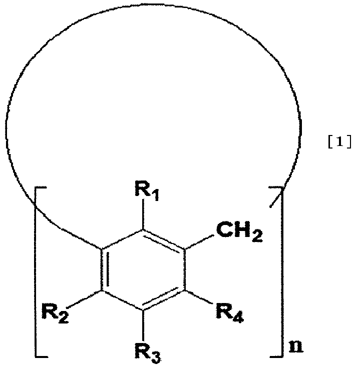 in the general formula [1], R₁ to R₄ represent hydrogen, a halogen atom, a hydroxy group, a substituted or unsubstituted aromatic hydrocarbon group, or a substituted or unsubstituted organic group each independently in each repeating unit and each independently for "n" repeating units, "n" represents an integer of from 3 to 20, and the compound has at least one hydroxy group in a molecule thereof.

7. The photoelectric conversion element according to claim 6, wherein in the general formula [1], "n" represents 4 or 8.

8. The photoelectric conversion element according to claim 6 or 7, wherein in the general formula [1], R₁s represent a halogen atom or a hydroxy group each independently for "n" respective repeating units, at least one R₁ represents a hydroxy group, and R₃s represent a nitrophenylazo group or a dinitrophenylazo group each independently for "n" repeating units.

9. The photoelectric conversion element according to any one of claims 1 to 8, wherein the charge-transporting layer contains, as the aromatic ring compound, at least one selected from the group consisting of: a compound represented by the following formula [C-1]; a compound represented by the following formula [C-2]; a compound represented by the following formula [C-3]; and a compound represented by the following formula [C-4].

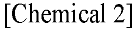

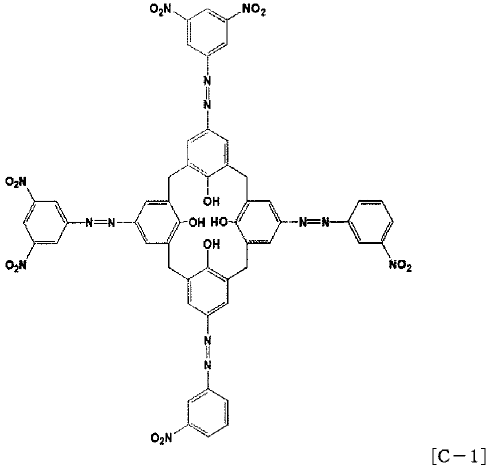

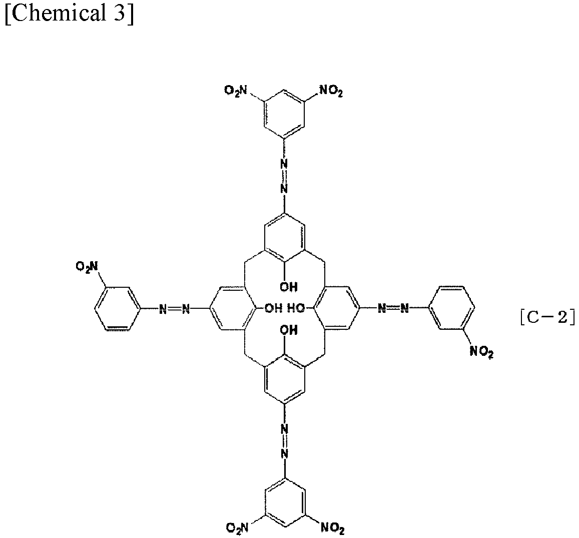

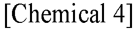

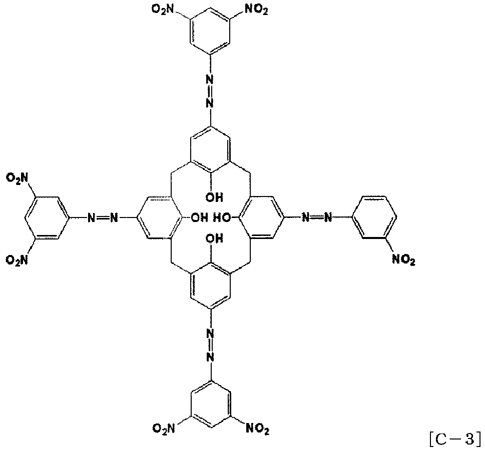

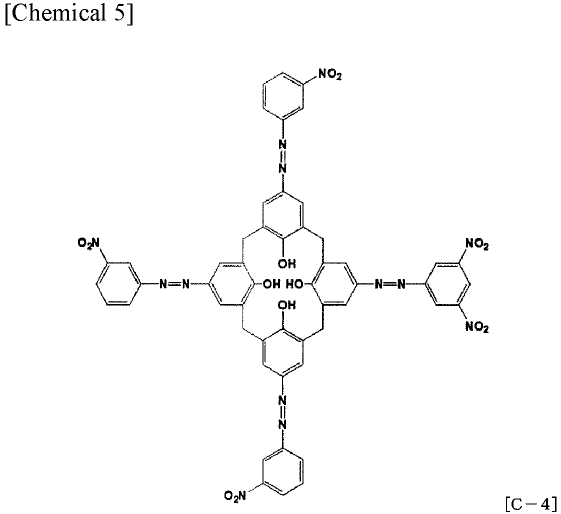

10. The photoelectric conversion element according to claim 9, wherein the charge-transporting layer contains, as the aromatic ring compound, the compound represented by the formula [C-1], the compound represented by the formula [C-2], the compound represented by the formula [C-3], and the compound represented by the formula [C-4].

11. The photoelectric conversion element according to any one of claims 1 to 10, wherein the aromatic ring compound has a molecular weight of 10,000 or less.

12. The photoelectric conversion element according to any one of claims 1 to 11, wherein the charge-transporting layer is brought into contact with the photoelectric conversion layer.

13. The photoelectric conversion element according to any one of claims 1 to 12, wherein the phthalocyanine compound is a metal phthalocyanine compound.

14. The photoelectric conversion element according to any one of claims 1 to 13, wherein the phthalocyanine compound is a gallium phthalocyanine compound.

15. The photoelectric conversion element according to any one of claims 1 to 13, wherein the phthalocyanine compound is a hydroxygallium phthalocyanine compound.

16. The photoelectric conversion element according to any one of claims 1 to 15, wherein the crystal having a perovskite structure is a crystal of a compound represented by the following general formula [2]:
R-M-X₃ [2]
in the general formula [2], R represents any one of an organic molecule or an inorganic atom, or both thereof, M represents a metal atom, and X represents a halogen atom or a chalcogen atom.

17. The photoelectric conversion element according to any one of claims 1 to 16, wherein, when a content of the phthalocyanine compound is set to 100 parts by mass, a content (part(s) by mass) of the aromatic ring compound in the charge-transporting layer is 0.5 part by mass or more and 50 parts by mass or less.

18. The photoelectric conversion element according to any one of claims 1 to 17, wherein the photoelectric conversion element comprises a hole-transporting layer between the charge-transporting layer and the first electrode.

19. The photoelectric conversion element according to claim 18, wherein the hole-transporting layer contains Spiro-OMeTAD as a hole-transportable compound.

20. A photoelectric conversion element comprising:
a first electrode;
a second electrode; and
a photoelectric conversion layer containing a crystal having a perovskite structure arranged between the first electrode and the second electrode,
wherein the photoelectric conversion element comprises, between the photoelectric conversion layer and the first electrode, a charge-transporting layer containing a hole-transportable compound and an aromatic ring compound represented by the following general formula [1]: 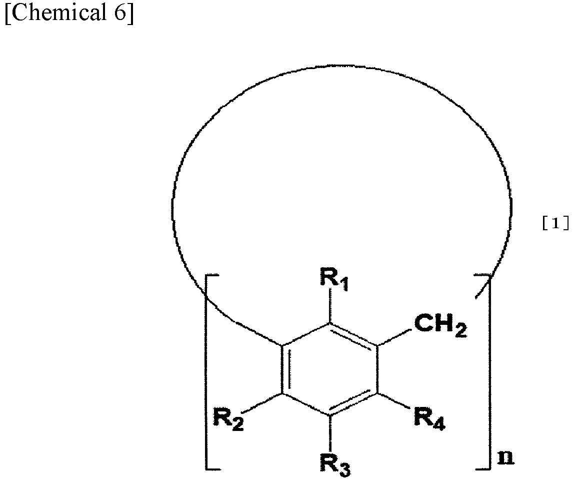
in the general formula [1], R₁ to R₄ represent hydrogen, a halogen atom, a hydroxy group, a substituted or unsubstituted aromatic hydrocarbon group, or a substituted or unsubstituted organic group each independently in each repeating unit and each independently for "n" repeating units, "n" represents an integer of from 3 to 20, and the compound has at least one hydroxy group in a molecule thereof.

## Amended claims

### Amended claims under Art. 19.1 PCT

1. A photoelectric conversion element comprising:
a first electrode;
a second electrode; and
a photoelectric conversion layer containing a crystal having a perovskite structure arranged between the first electrode and the second electrode,
wherein the photoelectric conversion element comprises a charge-transporting layer containing a phthalocyanine compound and an aromatic ring compound having a hydroxy group different from the phthalocyanine compound between the photoelectric conversion layer and the first electrode, and
a number of hydroxy groups in the aromatic ring compound is larger than the number of hydroxy groups in the phthalocyanine compound.

3. The photoelectric conversion element according to claim 1, wherein a number of hydroxy groups in the aromatic ring compound is 3 or more.

4. The photoelectric conversion element according to claim 1, wherein a number of hydroxy groups in the aromatic ring compound is 4 or more.

5. The photoelectric conversion element according to any one of claims 1, 3, and 4, wherein the charge-transporting layer contains a plurality of kinds of the aromatic ring compound.

6. The photoelectric conversion element according to any one of claims 1 and 3 to 5, wherein the aromatic ring compound is a compound represented by the following general formula [1]: 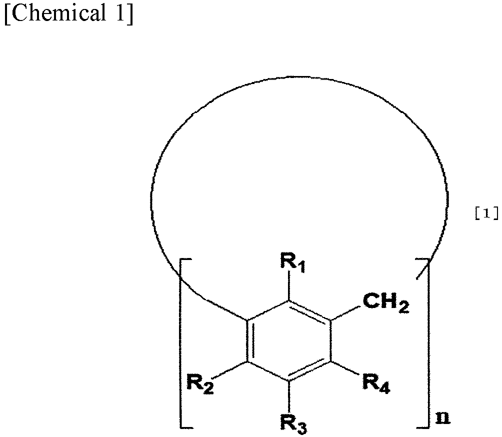 in the general formula [1], R₁ to R₄ represent hydrogen, a halogen atom, a hydroxy group, a substituted or unsubstituted aromatic hydrocarbon group, or a substituted or unsubstituted organic group each independently in each repeating unit and each independently for "n" repeating units, "n" represents an integer of from 3 to 20, and the compound has at least one hydroxy group in a molecule thereof.

7. The photoelectric conversion element according to claim 6, wherein in the general formula [1], "n" represents 4 or 8.

8. The photoelectric conversion element according to claim 6 or 7, wherein in the general formula [1], R₁s represent a halogen atom or a hydroxy group each independently for "n" respective repeating units, at least one R₁ represents a hydroxy group, and R₃s represent a nitrophenylazo group or a dinitrophenylazo group each independently for "n" repeating units.

9. The photoelectric conversion element according to any one of claims 1 and 3 to 8, wherein the charge-transporting layer contains, as the aromatic ring compound, at least one selected from the group consisting of: a compound represented by the following formula [C-1]; a compound represented by the following formula [C-2]; a compound represented by the following formula [C-3]; and a compound represented by the following formula [C-4].

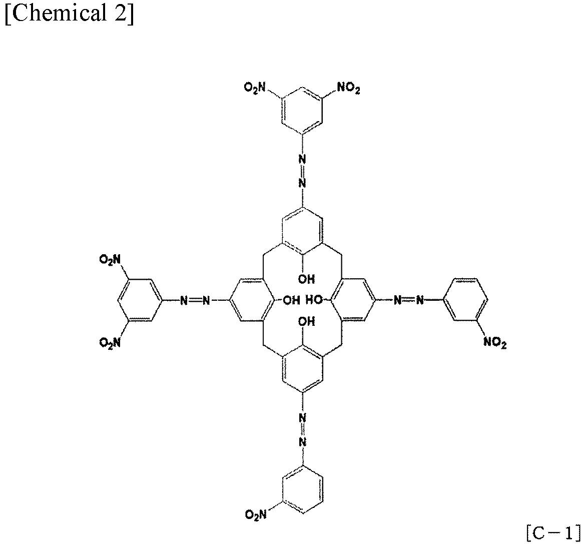

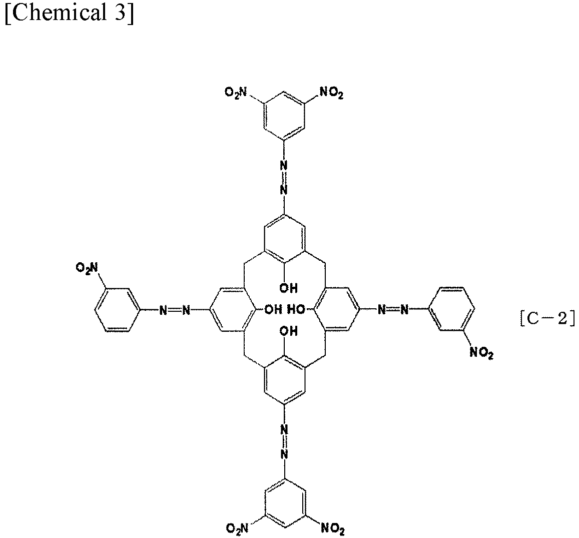

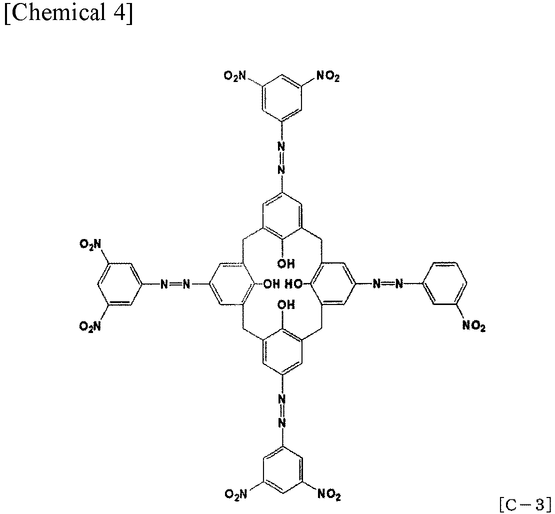

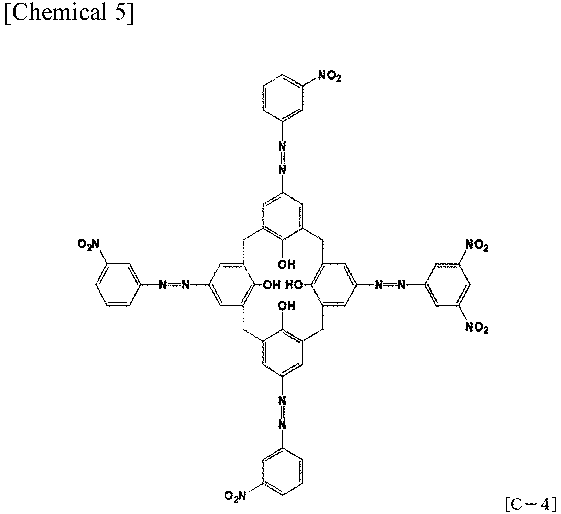

10. The photoelectric conversion element according to claim 9, wherein the charge-transporting layer contains, as the aromatic ring compound, the compound represented by the formula [C-1], the compound represented by the formula [C-2], the compound represented by the formula [C-3], and the compound represented by the formula [C-4].

11. The photoelectric conversion element according to any one of claims 1 and 3 to 10, wherein the aromatic ring compound has a molecular weight of 10,000 or less.

12. The photoelectric conversion element according to any one of claims 1, and 3 to 11, wherein the charge-transporting layer is brought into contact with the photoelectric conversion layer.

13. The photoelectric conversion element according to any one of claims 1 and 3 to 12, wherein the phthalocyanine compound is a metal phthalocyanine compound.

14. The photoelectric conversion element according to any one of claims 1 and 3 to 13, wherein the phthalocyanine compound is a gallium phthalocyanine compound.

15. The photoelectric conversion element according to any one of claims 1 and 3 to 13, wherein the phthalocyanine compound is a hydroxygallium phthalocyanine compound.

16. The photoelectric conversion element according to any one of claims 1 and 3 to 15, wherein the crystal having a perovskite structure is a crystal of a compound represented by the following general formula [2]:
R-M-X₃ [2]
in the general formula [2], R represents any one of an organic molecule or an inorganic atom, or both thereof, M represents a metal atom, and X represents a halogen atom or a chalcogen atom.

17. The photoelectric conversion element according to any one of claims 1 and 3 to 16, wherein, when a content of the phthalocyanine compound is set to 100 parts by mass, a content (part(s) by mass) of the aromatic ring compound in the charge-transporting layer is 0.5 part by mass or more and 50 parts by mass or less.

18. The photoelectric conversion element according to any one of claims 1 and 3 to 17, wherein the photoelectric conversion element comprises a hole-transporting layer between the charge-transporting layer and the first electrode.

19. The photoelectric conversion element according to claim 18, wherein the hole-transporting layer contains Spiro-OMeTAD as a hole-transportable compound.

20. A photoelectric conversion element comprising:
a first electrode;
a second electrode; and
a photoelectric conversion layer containing a crystal having a perovskite structure arranged between the first electrode and the second electrode,
wherein the photoelectric conversion element comprises, between the photoelectric conversion layer and the first electrode, a charge-transporting layer containing a hole-transportable compound and an aromatic ring compound represented by the following general formula [1]: 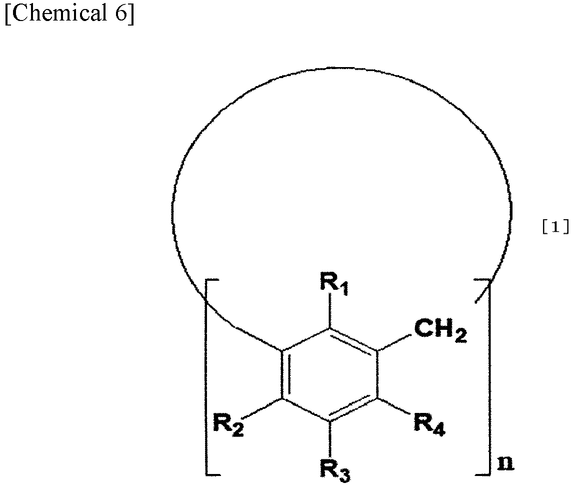
in the general formula [1], R₁ to R₄ represent hydrogen, a halogen atom, a hydroxy group, a substituted or unsubstituted aromatic hydrocarbon group, or a substituted or unsubstituted organic group each independently in each repeating unit and each independently for "n" repeating units, "n" represents an integer of from 3 to 20, and the compound has at least one hydroxy group in a molecule thereof.
